# EUROPEAN PATENT APPLICATION

(11) **EP 4 447 052 A1**
(43) Date of publication of application: **16.10.2024**
(21) Application number: 23167618.0
(22) Date of filing: 12.04.2023
(51) Int. Cl.: G11C 11/412, G11C 11/419

(54) **FAST, ENERGY EFFICIENT CMOS 2P1R1W REGISTER FILE ARRAY USING HARVESTED DATA**

(71) Applicant: Metis Microsystems, LLC, Newtown, CT 06470 (US)
(72) Inventor: BHAVNAGARWALA, Azeez, Newtown, 06470 (US)
(74) Representative: Cooley (UK) LLP

(57) **Abstract**

New CMOS harvesting circuits are proposed that improve 2-port/multiport Register File Array circuit speed *and* substantially lower the energy cost of moving data along local and global bitpaths *when engaging harvested data to self-limit energy dissipation.* The *uncertainty in BL signal development* due to statistical variations in cell read current is *eliminated* by self-disabling action in the selected cell when the *electric potential of harvested data matches the BL voltage from signal development* while demanding fewer peripheral circuit transistors per column than conventional sensing schemes. Proposed bit path circuits *engage harvested charge to provide immunity to disturb current noise during concurrent Read and Write access along a WL -* eliminating the performance, area and energy overheads of BL keeper circuits typically required in conventional Register File arrays. Proposed circuits *improve the reliability of Read performance-limiting bitcell devices from voltage accelerated aging mechanisms by lowering of vertical and lateral electric fields across these cell transistors* when holding harvested charge during most of active and standby periods. Register File bitcell transistor design trade-off constraints between array leakage in active mode and read current are considerably relaxed when engaging harvested charge *enabling much higher read currents for any given total array leakage.* Area overheads of proposed circuits are expected to be marginally lower based on device widths of replacements to conventional peripheral circuits and can be further minimized by sharing of devices and their connections between bit slices of the array peripheral circuits. Moreover, *proposed circuits do not require any changes to the CMOS platform, to the bitcell or to the array architecture* with much of the flow for design, verification and test of 2-Port/multiport RF Memory arrays expected to remain unchanged - *minimizing risk and allowing integration of proposed circuits into existing products with minimal disruption to schedule and cost.*

## Description

### 1. Background of the Invention

### A. Introduction

While chip power density of CMOS chips was held constant with constant electric field (Dennard) scaling for over 30 years [1], increases in CMOS device electrical variability at lower operating voltages and scaled geometries [2-4] in tandem with reductions in circuit speed from non-scaling of gate overdrive due to exponential increases in leakage from scaling MOSFET threshold voltages [5-6] have limited CMOS voltages from scaling to much below 1 V. These limitations brought an end to constant field scaling in 2004 [7]. With constant voltage scaling, chip power density increases [8] as the cube of scaling factor with heat removal inefficiencies limiting processor clock frequencies to below 5 GHz [9] making processor performance increasingly constrained by its energy efficiency.

The energy consumption for various arithmetic operations and memory accesses in [10] shows the relative energy cost *dominated by energy consumed from moving data in a memory access* that is higher than energy consumed for arithmetic operations. *Large* last-level caches are included on the CPU chip to scale memory stall time with performance by lowering the miss rate of the processor's caches. However, since most of the memory bitcells are idle most of the time, the energy dissipation of large on-chip CPU cache memory is dominated by its leakage with caches and register files (RF) consuming over 50% of the CPU's energy [10].

GPUs are widely preferred over CPUs to accelerate AI workloads because Deep Neural Network. (DNN) model training is composed of simple matrix math and convolution calculations, the speed of which can be greatly enhanced if the computations can be carried out in parallel. GPUs use tens of thousands of threads to pursue high throughput performance with extreme multithreading [11]. Extreme multithreading requires a complex thread scheduler as well as a large register file, which is expensive to access both in terms of energy and latency [12]. In GPUs, the bottleneck for DNN processing is in the memory access - with each multiply and accumulate (MAC) operation requiring three memory read accesses and one memory write access [13]. In energy efficient Dataflows that maximize data reuse and local accumulation of data, the energy consumed by Register File arrays contributes to nearly 70% of the energy of a MAC operation [13].

Each thread in a CPU must store its register context on-chip. Unlike CPUs that hide latency of a single thread by using a large last-level on-chip cache, GPUs use a large number of threads and switch between them to hide memory access latency [14]. Just holding the register context, of these threads requires substantial on-chip storage. With tens of thousands of threads, register file arrays are one of the largest on-chip memory resource in current GPUs [15] making the Register File & SRAM buffers the limiting factor on CPU performance, active power and leakage [16].

### B. Prior Art: Conventional 2-Port IRIW Register File Array Circuits

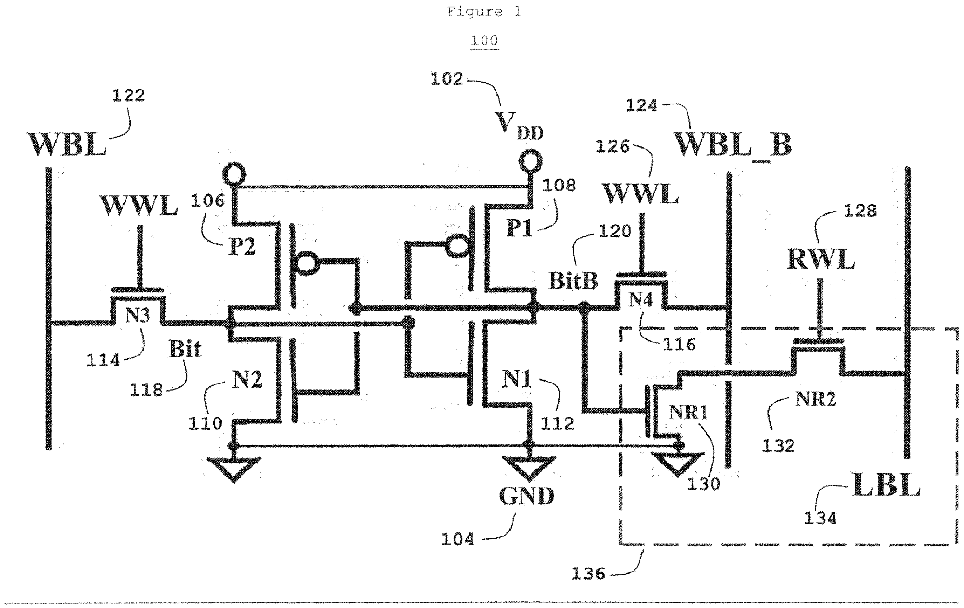

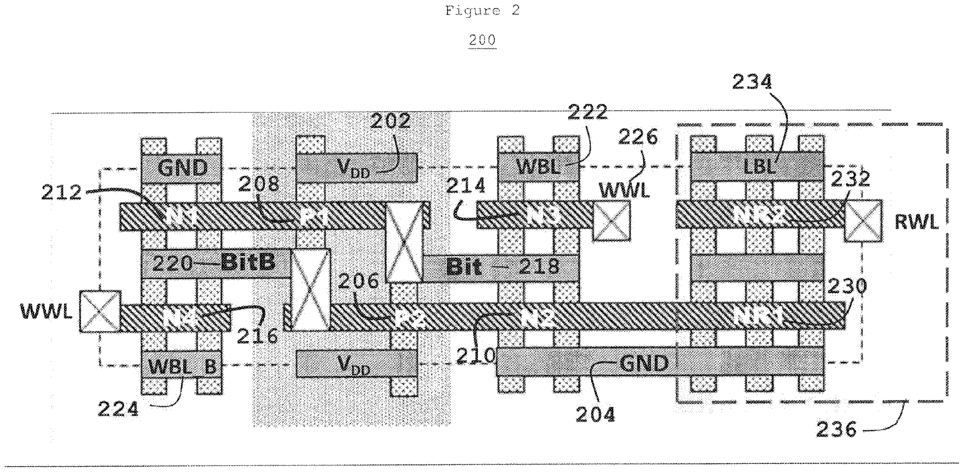

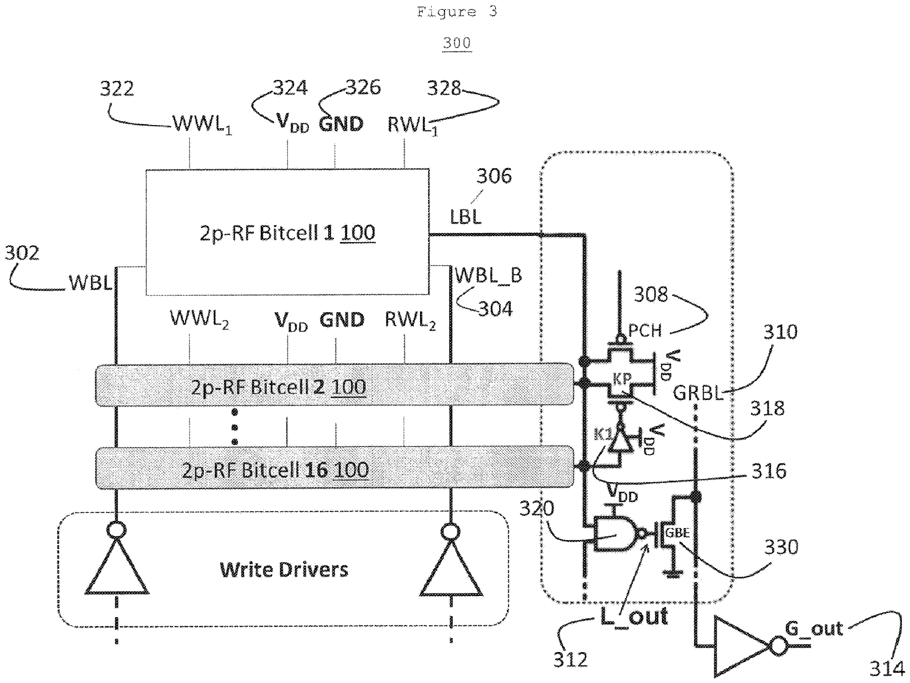

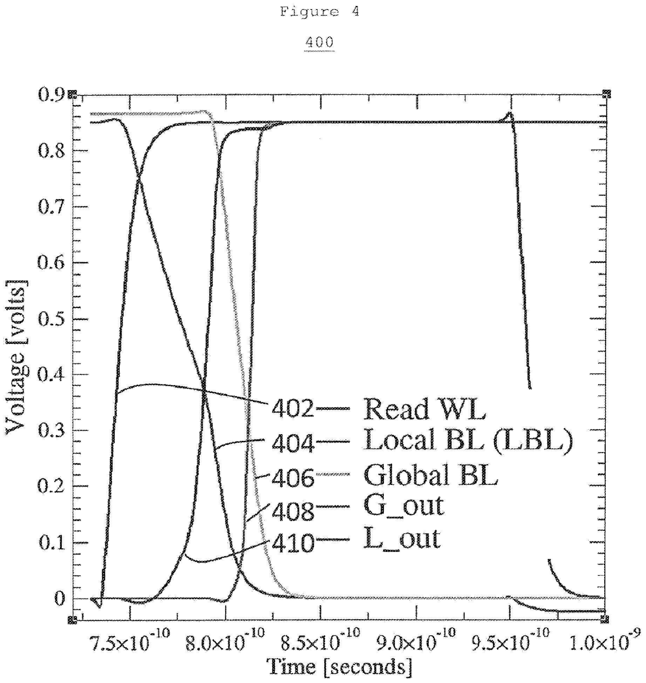

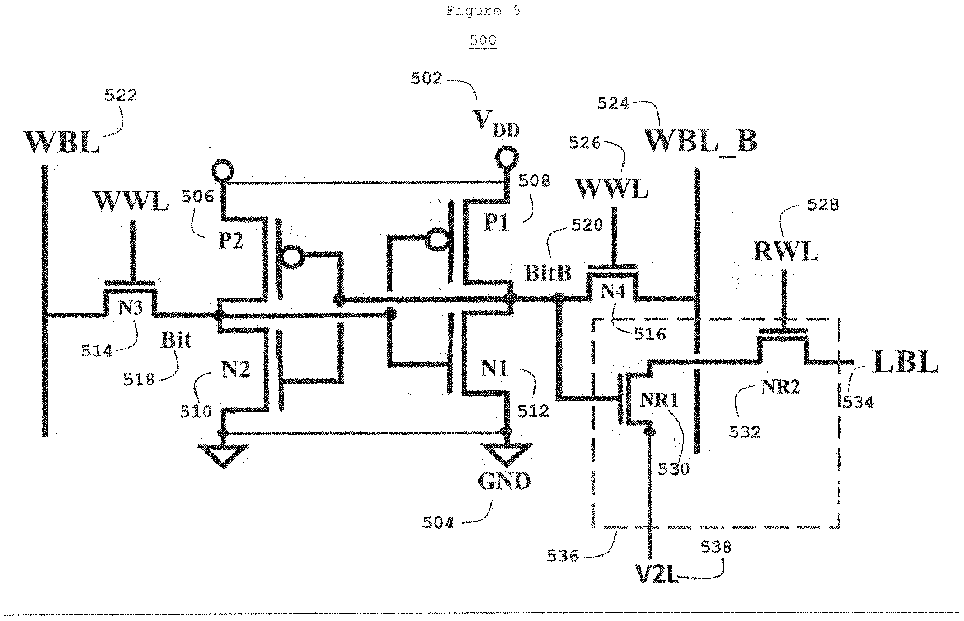

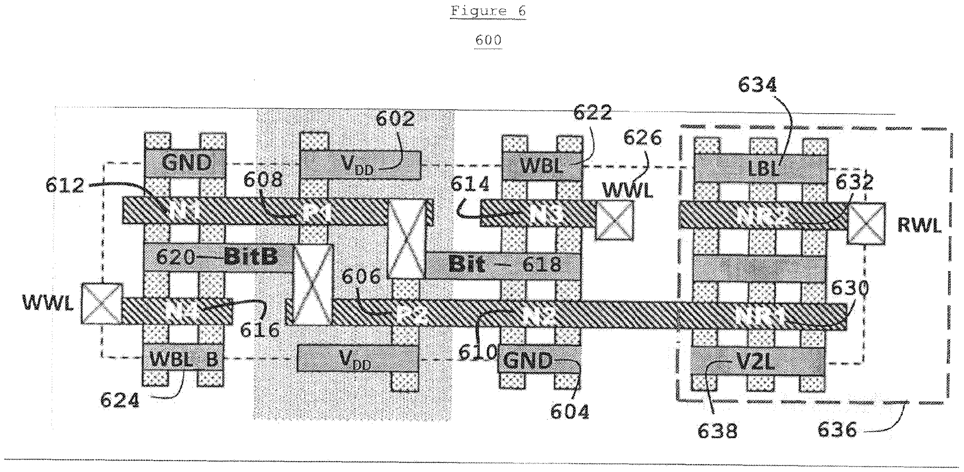

(i) *2 Port Register File (2P RF) bitcells* shown in Figure 1 100 (schematic) and Figure 2 200 (layout) provide, faster signal development rates on the LBL, 134, 234 and demonstrate lower VMIN when compared to conventional 6T SRAM bitcells. Primarily used when both Read and Write access to memory are desired in the same cycle for higher memory access throughput performance, 2P RF cells use fast NFET transistors - NR1 130, 2 3 0 and NR2 132, 2 32 in the read stack - shown in the dashed box 136, 236 to accomplish higher read current at the decoupled read port of the bitcell connected to the local bitline, LBL 134, 234. The decoupling of the read stack 13 6, 2 3 6 allows a higher read performance without being required to trade it off for higher read stability margins as is required in the 6T SRAM cell. The decoupled read stack also allows the Write margin at low voltages to be independently optimized for lower VMIN. The decoupled NFET Read stack (NR1 130, 230 NR2 132 , 232) in Figures 1 100, 2 200 driving the read port in the 2P RF bitcell ~ typically optimized for performance, *is also typically leakier than other bitcell devices.*
   The conventional 2P RF bitpath assumed (Figure 3 300) serves as a baseline reference relative to which improvements are typically reported by industry and academia alike [17-20]. All of these recent (within last 4 years) references assume this `Domino Read' full-swing bitline approach as the baseline reference to compare their Register File array implementations with.
(ii) *Full-Swing, Short-BL sensing with Logic Gates:* Small signal differential sensing - typically used in 6T arrays due to small area overheads and robust operation, is not as attractive for RF arrays because differential sense amps do not track delay scaling in logic circuits and because the small signal development rate on the bitline depends on bitline loading capacitance ∼ dominated by local interconnects in each bitcell which don't scale with device geometries [21]. The scaling of transistor dimensions also degrades random mismatch at the sense amplifier input [22] that translates into larger sense amplifier voltage offsets the BL signal must overcome as a performance overhead.
   Alternative large signal sensing schemes for RF arrays, shown in Fig 3 use a NAND gate [21] and short bit lines (16/32 bitsBL). In the `Domino Read' scheme, static CMOS circuits for sensing, short bitlines and rail-rail swings on bitlines eliminate the performance scaling issues seen with differential sensing while the global bitline at an upper metal level routes sensed data across the height of the array at low resistance. This scheme is widely adopted across industry for 2P RF arrays enabling them to deliver much higher performance in GPUs that scales with logic gate technology at a high cost in (GPU) chip size and in switching and leakage power.
(iii) *Dynamic Read Access:* Dynamic circuits that precharge output nodes so they evaluate much faster on arrival of the clock edge with inputs stable during evaluation - are found in practically all fast memory arrays. Precharge of local and global bitlines and their evaluation by bitcell at the arrival edge of the Read WL select transition are an example in 2P RF bitcell arrays. However, these techniques are energy inefficient since all of the charge discarded (from the LBL and the GRBL in Fig 4) to the reference ground potential during evaluate must be resupplied during the BL precharge phase before the next Read cycle. In a typical 2P RF Array Instance [23], as many as 256 local BL columns are accessed by a Read WL in an 8KB instance. However, only a few rows in the WL direction are selected during the same cycle (Read WL, Write WL, Precharge and a few other control signals in the WL direction) making the bit path in a 2P RF array from bitcell to output latch, the dominant (>95%) energy consumption component in a 2P RF array.
(iv) *Disturb Current Read Failure avoidance with BL Keeper*: The read stack 13 6, 236 in Figure 1 100, 2 200 also increases the risk of read failure from disturb current [24] if data at cell node 'BitB' 120, 220 in Fig 1 100 & Fig 2 200 is a '0' during a concurrent read and write access along the same WL. Because the Write WL half selects the bitcell (write BL pair [WBL. WBL_B] are both precharged to V_{DD}), the cell node 'BitB' at '0' typically rises 100-150 mV due to the voltage divider across N1 and N4, partially turning on NFET NR1 130, 230 in the read stack 136, 236. At relevant fast N, high T corners (where additional noise by way of VT reductions due to temperature, process and random variations) the local bitline (LBL) 134, 234 begins evaluating (with a lower read current) as the gate input of NR1 rises to an effective noise voltage assumed as 300mV in circuit simulations below. This noise level is sufficient for the bitpath to read out the wrong data at slower cycle times, given a sufficiently wide distribution of Read current in the RF bitcell [24]. Examples of the industry-wide adopted solution [23-26] for this read failure mechanism is to add keeper circuitry K1, KP (316, 318) in Figure 3 300 where KP is driven by feedback inverter K1 from the local bitline shown in Fig 3 . The impact on signal development time on the LBL at the low T, slow NP corners where the selected bitcell must fight the keeper KP (already in the saturation region) harder to develop signal can be as high as a 20+% signal. development time degradation [23].
(v) *An Industry Solution to Disturb Current read failure*: One alternative solution to the keeper approach described above, for disturb current read failure has been to use PFETs instead of NFETs for access devices N3, N4 in the 2P RF bitcell driven by the Write WL [23] using precharged-low Write BLs in half-selected bitcells during simultaneous read and write access of the 2P RF bitcell. This solution eliminates the voltage bump at the gate of the Read stack device NR1 in the when 'BitB' is 0, but the on-current of NR1 is degraded by up to 35%[23] due to a drop in the high node storage level at 'BitB' when both RWL and WWL in the same row are simultaneously turned on - effectively degrading read current. In [23] the RWL voltage is bootstrapped by 15-20% to recover performance when using Write PFET access transistors to eliminate Disturb Current driven Read failure. The power & area overheads in doing so appear significant given the size of bootstrap capacitors required to deliver sufficient charge to the WL. Also, this solution assumes approximately equal drive strengths of NFETs and PFETs due to the introduction of embedded Si/Ge source/drain that enhances hole mobility. Absent this feature in older CMOS platforms, other complications of lowering write margins (and raising write VMIN) could arise when using weaker PFET instead of NFETs as access devices driven by the write WL.
(vi) *High Leakage through Fast Read Stack*: Another negative consequence of the use of the Keeper PFET solution is that when the local bitline LBL 3 0 6 is held at V_{DD} by the keeper KP, 318 during active or standby mode, all bitcells connected to the local bitline, are draining high leakage current from the bitline (due to a drop of a full V_{DD} across the NFETs in the read stack) through an already leaky stack - some of which are worse (whose bitcells have `BitB' = 1 turning on the lower of the two devices in the Read stack). These leakage paths are `live' for all local bitlines across the aggregate RF array in a GPU during active mode and for all bitlines except those discharged in the last access before entering inactive mode.
(vii) *Reliability of NR1 in read stack*: NMOS transistor aging mostly arises from positive bias temperature instability (PBTI), hot carrier injection (HCI) and time-dependent dielectric breakdown (TDDB). In an NFET stack 136, 236 in Fig 1 100*,* 2 200 a '1' at 'BitB' that drives the gate input of transistor NR1 130, 230 in the Read stack of the 2P RF bitcell, could assert PBTI stress on NR1 with V_{DD} asserted between the Gate-to-Source and Gate-to-Drain terminals over extended periods [27]. A full V_{DD} also drops along the channel of NR2 during inactive modes leading to high sustained lateral fields when the local bitline is held at V_{DD} with keeper circuitry. The VT shift of NR1 due to PBTI in 6T SRAM bitcells where the pull-down inverter NFET experiences a similar voltage stress is reported in [28] for stress times up to 100M secs (3 years) of 10-15mV. This PBTI shift in NR1 due to high vertical fields can add to HCI driven shifts in NR2 due to high lateral fields to degrade read stack current/performance and variability in a 2P RF cell.
(viii) *Multi-port Register File arrays*: Note that while this invention details the circuit schemes proposed for a 2P RF register file bitcell array, these are easily extended to Register File arrays with additional i Read Ports by adding NFET transistor pairs (corresponding to the Read stack 536, 636 in Fig 5 500, Fig 6 600) for each additional Read port with the gate input of the lower NFET ~ NR1ᵢ; driven by the cell storage node 'BitB' and the gate input of the upper NFET in the stack, NR2ᵢ driven by the Read Word Line for each Read port, RWLᵢ. The source terminal of NR1ᵢ is connected to a harvesting node V2Lᵢ for each Read port i.

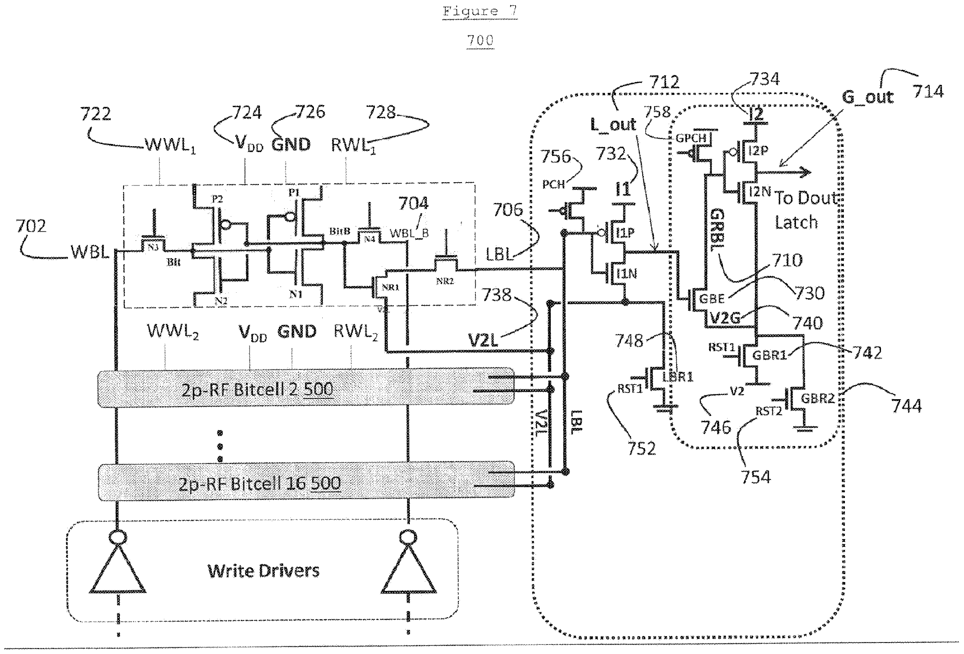

Similarly, each additional Write port j is added to the schematic in Fig 5 500, 600 of the 2P RF bitcell by including j pairs of NFET PG devices N3ⱼ and N4ⱼ that connect the cell storage nodes to j pairs of local Write bitlines - WBLⱼ, WBL_Bⱼ with each of j pairs of NFET PG devices N3ⱼ, N4ⱼ driven by the Write Word Line for each Write port, WWLⱼ at their gate inputs. The peripheral circuits associated with the local and global bitline for each read/write port i/j are identical to those described in Fig 7 700

### 2. Brief Summary of the Invention

New CMOS harvesting circuits are proposed that improve 2-port/multiport Register File Array. circuit speed *and* substantially lower the energy cost of moving data along local and global bitpaths *when engaging harvested data to self limit energy dissipation. The uncertainty in BL signal development* due to statistical variations in cell read current is *eliminated* by self-disabling action in the selected cell when the *electric potential of harvested data matches the BL voltage from signal development* while demanding fewer peripheral circuit transistors per column than conventional sensing schemes. Proposed bit path circuits *engage harvested charge to provide immunity to disturb current noise during concurrent Read and Write access along a WL -* eliminating the performance, area and energy overheads of BL keeper circuits typically required in conventional Register File arrays. Proposed circuits *improve the reliability of Read performance-limiting bitcell devices from voltage accelerated aging mechanisms by lowering of vertical and lateral electric fields across these cell transistors* when holding harvested charge during most of active and standby periods. Register File bitcell transistor design trade-off constraints between array leakage in active mode and read current are considerably relaxed when engaging harvested charge *enabling much higher read currents for any given total array leakage.* Area overheads of proposed circuits are expected to be marginally lower based on device widths of replacements to conventional peripheral circuits and can be further minimized by sharing of devices and their connections between bit slices of the array peripheral circuits. Moreover, *proposed circuits do not require any changes to the CMOS platform, to the bitcell or to the array architecture* with much of the flow for design, verification and test of 2-Port/multiport RF Memory arrays expected to remain unchanged - *minimizing risk and allowing integration of proposed circuits into existing products with minimal disruption to schedule and cost.*

### 3. Brief Description of Drawings

*Figure 1* 100 shows the schematic of a Conventional 2P RF bitcell. Cell transistor, circuit node and cell terminal names are identified.
Figure 2 200 shows the layout of an industry typical 8 transistor 2P RF bitcell [23]. *Figure 2* 200 is frequently referred to in the Spec along with *Figure 1**.* Cell transistor, circuit node and cell terminal names are identical to those in the circuit schematic shown in *Figure 1**.* Typical of high performance 2P RF bitcells, this has fast NFETs in the Read Stack that are 3 fins wide.
*Figure 3* 300 shows the Circuit schematic of a conventional 2P Register File CMOS bit path. Typical of most 2P RF array bitpaths, it embodies keeper circuits to avoid read-disturb during concurrent Read and Write access to the same Word Line, uses a `Domino Read' large signal sensing scheme, a local and global bitline hierarchy and a short bitline (16b) architecture
*Figure 4* 400 shows the waveforms of key circuit nodes along the bitpath of a conventional 2P RF array. Response of the local and global bitline to a Word Line select transition and also the signal outputs of the local and global bitpaths
*Figure 5* 500 shows how the circuit schematic of the conventional 2P RF bitcell is used to implement proposed harvesting scheme where the reference ground terminal of the Read Stack NFET pair in the conventional 2P RF bitcell serves as the harvesting node in proposed scheme.
*Figure* 6 600 shows the layout of an industry typical 8-transistor 2P RF bitcell [23] with the Ground terminal of the read stack electrically isolated as the harvesting node V2L from the ground terminals of the pull down NFETs of the 6T part of the 2P RF bitcell. As with Figures 1 and 2, Figures 5 & 6 are frequently referred together in the Spec with Cell transistor, circuit node and cell terminal names in Figure 6 identical to those in the circuit schematic shown in *Figure 5**.*
*Figure* 7 700 shows the circuit schematic of an embodiment of the proposed 2P RF bitpath. Highlight of the proposed schematic is the harvest of evaluation charge and its use to double the sense speed, eliminate uncertainty of bit line signal development, substantially lower active power of a read access and do so with fewer peripheral circuit transistors than conventional large signal sensing or differential sensing schemes.

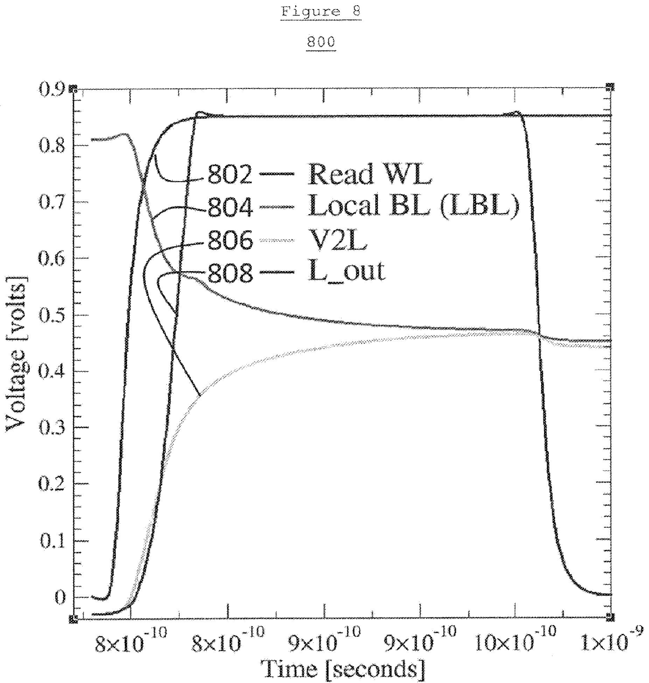

*Figure 8* 800 shows the waveforms of key circuit nodes along the proposed local 2P RF bitpath. Response of the local bitline and the local harvesting column (node V2L) of the accessed bitcell shows that the *data from the accessed cell is sensed without loss of any of the precharge on the local BL.* None of the electric charge the local bitline is precharged with is drained to ground - it is all harvested. Secondly, the *voltage signal developed on the local BL is no longer variant with the read current* of the accessed bitcell - it is determined by the capacitive divider between the local bitline and the harvesting column node making this voltage signal developed on the local bitline deterministic and not uncertain as in conventional 2P RF bitpaths. Thirdly, the *signal development* on the local BL *self-disables* as the electric potential of harvested data on node V2L rises to equalize the dropping voltage of the local bitline turning off the read current *even if the WL may still be selected.* Secondly, the *voltage signal developed on the local BL is no longer variant with the read current* of the accessed bitcell - it is determined by the capacitive divider between the local bitline and the local harvesting column node making this voltage signal developed on the local bitline deterministic and not uncertain as in conventional 2P RF bitpaths. Thirdly, the *signal development* on the local BL *self disables* as the electric potential of harvested data on node V2L rises to equalize the dropping voltage of the local bitline turning off the read current *even if the WL is still selected*

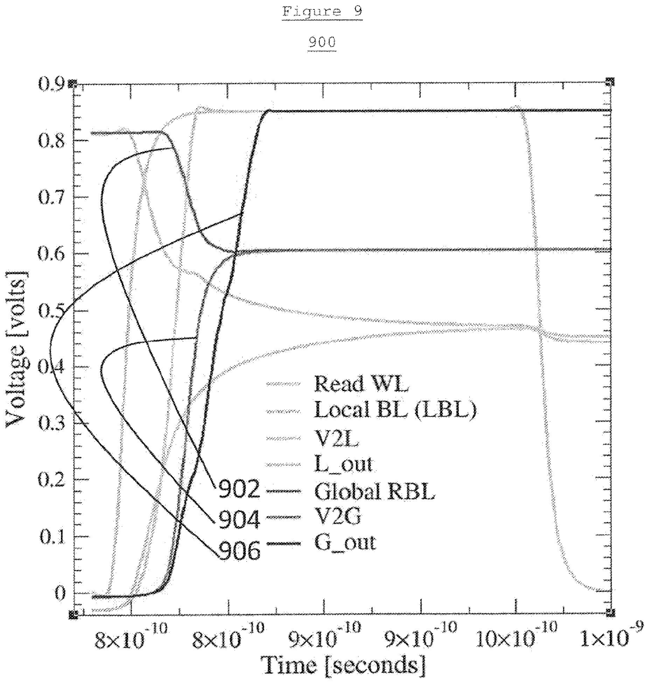

*Figure 9* 900 shows the waveforms of key circuit nodes along the proposed 2P RF global bitpath. Response of the Global Read Bitline and the global harvesting column (node V2G) of the accessed bitcell shows that the *data from the accessed cell is also sensed without loss of any of the precharge on the Global Read BL.* None of the electric charge the global bitline is precharged with is drained to ground - it is all harvested. Secondly, *the voltage signal developed on the Global Read BL is also determined by the capacitive divider between the Global Read Bitline and the global harvesting column capacitance* making this voltage signal developed on the global bitline also deterministic and not uncertain as in conventional 2P RF bitpaths. Thirdly, *the capacitive divider can be implemented so that only a fraction of the charge on the global bit line is sufficient to resolve the data* sensed. Fourthly, the *signal development* on the Global Read Bitline *self-disables* as the electric potential of harvested data on node V2G rises to equalize the dropping voltage of the Global Read Bitline turning off Global Read Bitline discharge *even if the Global Bitline Evaluation NFET is evaluating.*

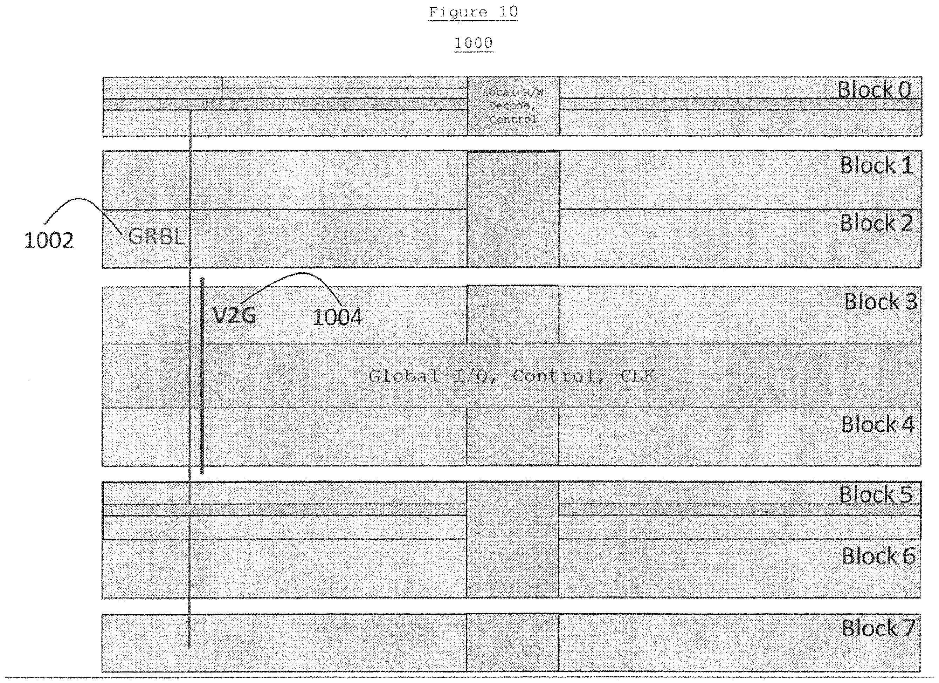

*Figure 10* 1000 shows an example global bitpath where a Global bitpath can accomplish a capacitive divider of 35% (C_{V2G}/C_{GRBL} = 0.35) by having the Global Bitline Evaluate (in Fig 7, GBE 730) NFETs in the schematic shown in Figure 7 placed between Blocks 2 and 3 and between Blocks 4 and 5 in Figure 10. This capacitance divider leads to the V2G harvest node rising to 1/1.35 of (V_{DD} =0.8V) or 0.6V - as illustrated in the waveforms shown in Figure 9 900

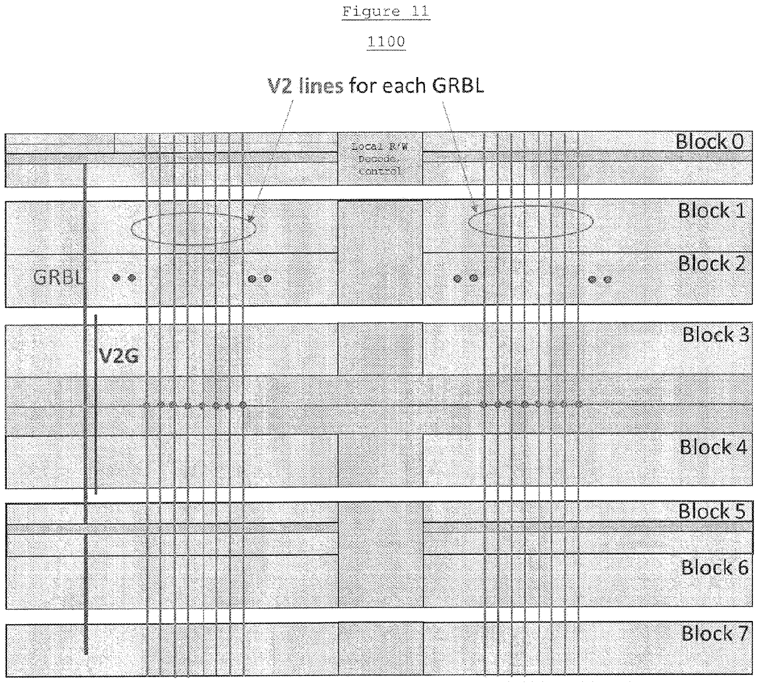

*Figure 11* 1100 shows the V2 grid (7 4 6 in Figure 7) in the 2P RF array corresponding to the node to which the charge harvested at V2G in each bit column is discharged to raising the electric potential of the V2 grid to a maximum of 0.6V assuming the capacitive divider of 35% between the Global Read Bitline GRBL and the global bitline harvesting node V2G. Charge harvested on the V2 grid at 0.6V can be used to partially power 0→1 logic transitions with circuits described in Application 17/497,974. These circuit can drive the WL, Data along the global Write Bitline, high fanout decoders or repeaters along global signaling routes.

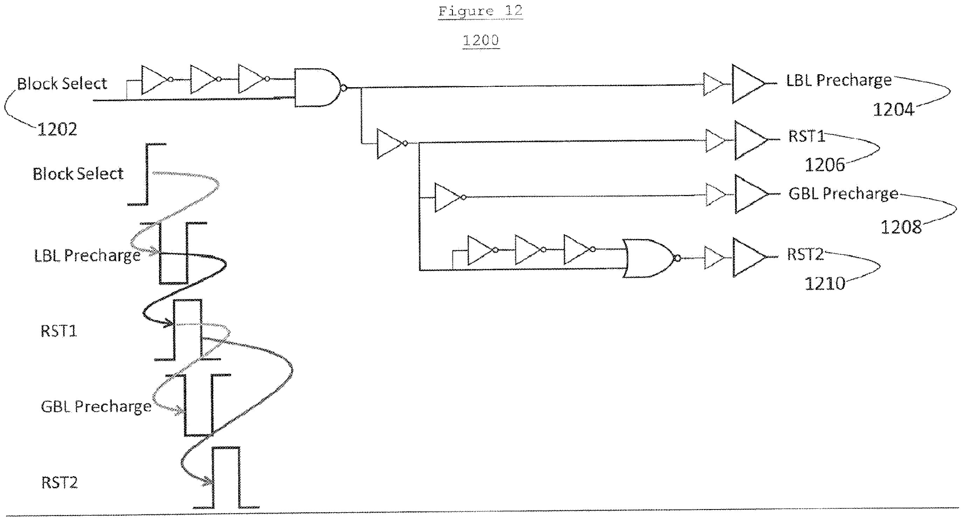

*Figure 12* 1200 shows the simple pulse generator circuits developed to drive the set of 4 interlocked pulses required by the local and global bitpath right before each Read access to precharge the local and global bitlines, to reset the local, global harvesting nodes and to move harvested charge from the global bitline harvesting node V2G to the V2 grid described in Figure 11.

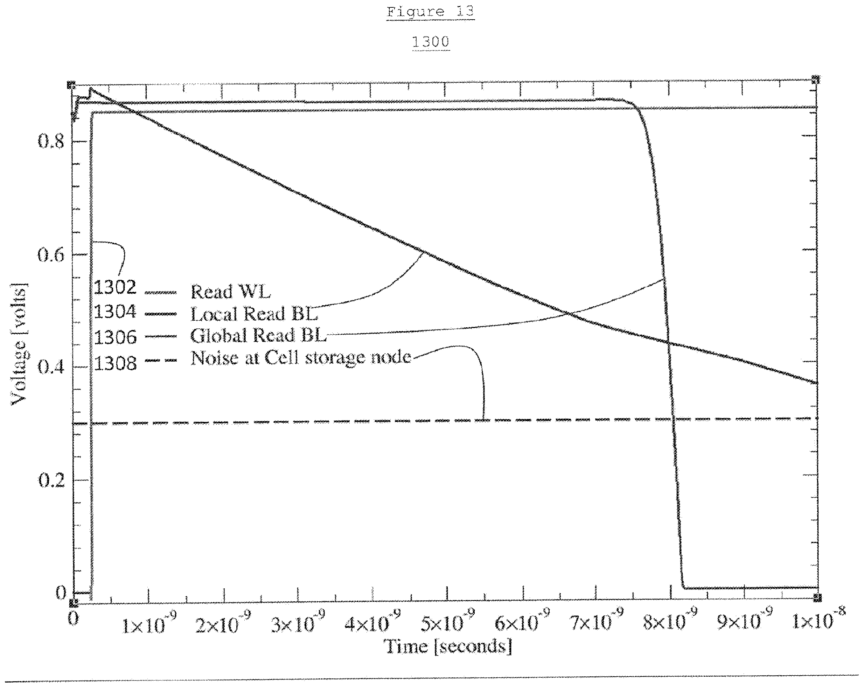

*Figure 13* 1300 shows the read disturb failure where the local and global read bitlines accomplish a false evaluation due to presence of noise at the cell storage node 'BitB' 120, 220 in Figures 1 100, 2 200 during a simultaneous Read and Write access to the same row of 2P RF bitcells. This simulation assumes the keeper circuit scheme 316, 318 in Figure 3 300 is not used.

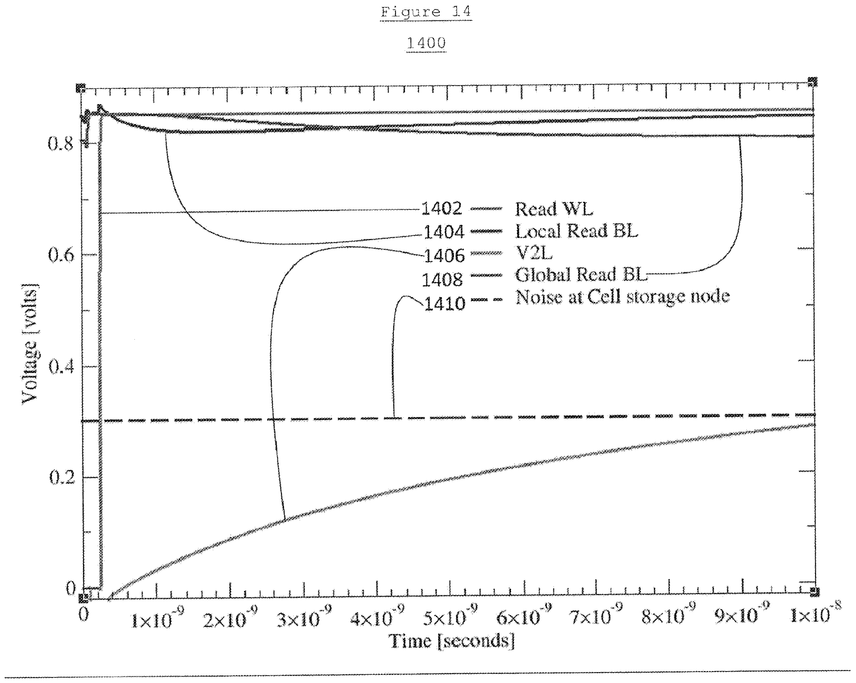

*Figure 14* 1400 shows the avoidance of read disturb failure when using the bitpath shown in Figure 7 700 without the use/need for Keeper circuits since the presence of noise at cell node 'BitB' 520, 6 2 0 in Figures 5 500, 6 600. Collection of harvested charge on the local harvesting node V2L self-disables the flow of spurious read current as the local harvesting node V2L approaches the noise voltage at 'BitB'.

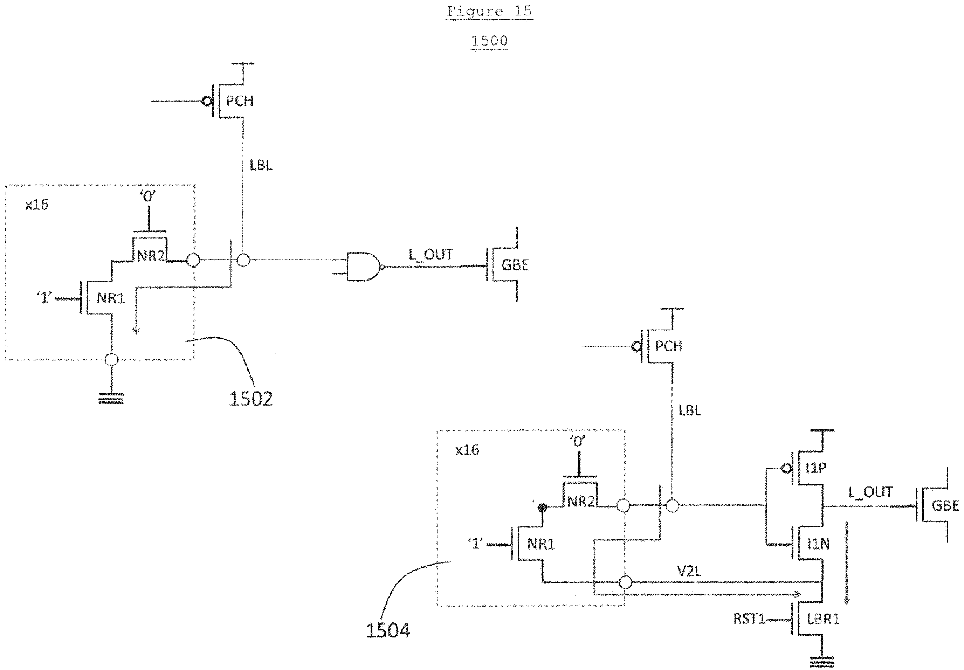

*Figure 15* 1500 shows the dominant leakage path schematic for a conventional 2P RF column of bitcells and the leakage path schematic for the proposed 2P RF column of bitcells assuming the same number of bitcells per local bitline. In both cases, the read stack dominates the leakage from bitcell since the read stack devices are typically higher performance than the other bitcell devics. The conventional bitpath has as many leakage paths as bitcells that share local bitline whereas the proposed bitpath has only one leakage path through the local bitline reset device LBR1 7 5 2 in Figure 7 700.

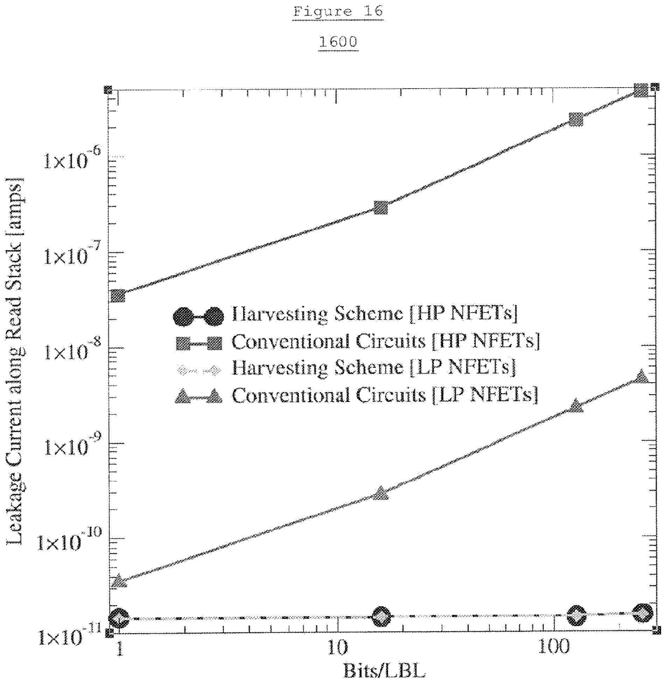

*Figure 16* 1600 shows the leakage current from a bitcell column as a function of the number of bitcells per column. The proposed bitpath leakage remains unchanged since the number of leakage paths are fixed and they are independent of the number of bitcells per local bitline.

### 4. Detailed Description of the Invention

### A. Operation of Proposed 2P RF array bitpath

*1. Harvest of LBL & GRBL Evaluation Energy.* In the 2P RF bitcell schematic in Figure 5 500, the Source terminal of the NFET NR1 5 3 0 in the Read Stack 5 3 6 is connected to local bitline harvesting node 'V2L' 5 3 8 ~ a metal line 738 shared by V2L terminals of bitcells that share the same local bitline 706 in the bitpath schematic shown in Figure 7 700. The harvesting node V2L 738 has a comparable capacitance and resistance to the local bitline LBL 706 in Figure 7 700 because the NFET stack typically has identical width devices NR1 530, 630 and NR2 532, 632 as seen in Figure 6 600 with identical device capacitance contributions to either of the nets LBL 706 and V2L 7 3 8 in the bitpath schematic shown in Figure 7 700. Since the wire lengths of nets LBL and V2L are also practically identical we can expect to see C_{LBL} equal to C_{V2L}

The Read access proceeds in the proposed bitpath shown in Figure 7 700 as with a conventional 2P RF bitpath, except that *all of the charge flowing into the selected bitcell* with `BitB' = 1, from the precharged local bitline LBL 706 in any given column - *is harvested on V2L 738.* This harvesting action raises the voltage on the local harvesting node V2L 738 at the same time and at the same rate of that voltage on the local bitline LBL 706 is lowered. This harvesting action practically doubles the signal development rate of the voltage asserted at the gate-source input of the sense-amp (inverter I1 732 in Figure 7 700), until the read stack in the selected 2P RF bitcell self-disables because the voltage at V2L 738 has risen to within a VT of the local bitline LBL 706. (Note that the implementation could use a 2-way NAND gate with active high column select as the second input (or a 2-way NOR gate with active low column select) instead of inverter Il 732. The self-disabling action occurs when the read stack devices of the selected bitcells have insufficient gate overdrive to stay in the linear region and move into the subthreshold region as LBL 706 and V2L 738 converge in voltage (Shown by waveforms in *Fig 8* *for proposed local bitpath*). In this scheme, logic circuits used, deliver the benefit of sealing sensing speed with the CMOS platform without the burden of having to consume the energy of full swing operation - as conventional 2P RF arrays are required to.

The uncertainty in signal voltage developed by a conventional 2P RF bitpath due to the variability of read current through the read stack of the 2P RF bitcell would translate into higher energy consumption because the WL pulse width would have to be margined for the slowest bitcell which simply gives more time for all of the other bitcells in the array to discharge their precharged bitlines longer to lower voltages directly increasing the energy required to precharge them for a following read access. In the proposed bitpath, on the other hand, the voltage signal developed on the local bitline is the same and is determined by the capacitive divider between the local bitline LBL and the local harvesting node V2L which demonstrates much lower variability than small geometry bitcell transistors. The time taken for the slowest bitcell in the proposed datapath to resolve the data read from the bitcell is also half of the conventional bitpath due to the dual ended action at the input of the sensing circuit I1 732 in Figure 7.

Similar harvesting action and dual ended sensing along the global bitpath in Figure 7 enables the global bitpath to also harvest all of the precharge on the Global Read Bitline GRBL 710 onto the global bitline harvesting node V2G 740 in Figure 7 700. Global sensing delay is also half of the corresponding delay in a conventional bitpath and without the uncertainty of signal development along the global read bitline GRBL 710, the energy consumed by the global bitpath is mostly harvested onto the V2 grid through NFET GBR1 742 directly before a Read access. Waveforms of the local and global bitpath in Figures 8 800 and 9 900. Control signals directly before a read access for the local and global bitpaths are generated as a set of 4 interlocked pulses that harvest, reset and precharge the bitpath as illustrated in Figure 12

The capacitance of V2L is fixed and cannot be changed to charge V2L to a different voltage. So, the sensing inverter for the local BL, I1 triggers when LBL and V2L are within a VT of each other causing its output L_out to make a 0→1 transition as seen in Figure 8 800 as well. The capacitance of V2G 740 can be designed to be 35% of the capacitance of the Global Read Bitline GRBL 710 using the placement scheme of the Global Bitline Evaluate (GBE) NFETs in the global bitpath as shown in a generic 8 block 2P RF array instance in Figure 10 1000. By sizing the global harvesting line V2G 740 to 35% of the capacitance of the Global Read Bitline GRBL 710 the GBE devices self-disable when V2G has harvested merely 25% of the charge on the GRBL to be able to resolve the data sensed by the Global bitpath. This smaller voltage swing on the GRBL in tandem with dual ended sensing by I2 734 enables substantial (over 2X) improvements in the WL →G_out delay without changing operating voltages, the CMOS platform or the array architecture. Moreover, with substantially reduced voltage swings and no uncertainty in signal development in tandem with a complete harvest of evaluation charge in the local and global bitpaths enable over 3X reductions in active energy consumption when using the proposed bitpath.

*2. Fast, energy and area efficient Sense amp action:* As the LBL voltage drops during a read access due to BitB = 1, the gate input voltage of Il 732 approaches Il's logic threshold, which itself moves to a higher voltage as voltage of V2L 738 rises with more harvested charge. As the LBL 706 voltage meets the rising logic threshold voltage of Il 732, the output of I1: L_out 712 rises fast due to the high gain of a CMOS inverter. Since L_out 712 directly drives the gate input of NFET GBE 730, GBE turns on and the precharged Global Read BL (GRBL) begins discharging as soon as L_out makes its 0→1 transition past the device threshold voltage of NFET GBE.

The global bitline harvesting node V2G 740 collects the precharge on GRBL 710 during a read access when resolving data corresponding to BitB=1 in the accessed bitcell. As with the LBL, the converging voltages on GRBL 710 and V2G 740 trigger a low→high transition at the output of inverter I2 734. A dropping GRBL voltage meets the rising logic threshold voltage of I2 734. The converging waveforms of GRBL 902 and V2G 904 (waveforms shown in Figure 9 900) self-disable the NFET GBE 730 in the proposed bitpath.

An imbalance capacitive divider is pursued in the Global BL to raise the voltage of V2G 740 higher than ½ V_{DD} so that V2G 740 can self-limit GRBL discharge sooner, at a voltage closer to V_{DD} than to GND and can this consume much less charge from the V_{DD} grid while resolving the same data as a conventional bitpath.

Figure 11 shows the V2G line at about 35% of the length of GRBL - requiring the Global bitpath circuits: NFET GBE 730, inverter I2 734 and reset NFETs GBR1 742 and GBR2 744 to be placed b/w blocks 2 & 3 and b/w blocks 4 & 5. This placement allows V2G 740 to rise to over 70% of V_{DD} limiting the charge harvested by V2G 740 from GRBL 710 on evaluate to less than 30% of what is typically dissipated from an equivalent industry-standard RF Global Read BL. Note that the sense amp action is much faster than the full-swing approach in conventional arrays because the signal development rate seen by I2 734 is double and the signal swing is a fourth of what would be seen on Global Read BL in a conventional RF array.

*3. Reset of Dynamic nodes before Read Access:* The Block Select signal from pre-decoders (Fig 12 1200) triggers a set of 4 interlocked pulses to condition the local and global Read bitpath before the RWL select edge arrives. They condition the bitpath for fast evaluate and also condition the harvesting nodes V2L 738 and V2G 740 to 'reset' to GND before the selected bit cells begin evaluating. Charge harvested on V2G for each bit column from a previous Read is first moved to the grid V2 by GBR1 742 whose gate is driven by pulse RST1 752. Key requirement on RST1 is that it discharge V2L when RST1 drives gate input of NFET LBR1. Discharge of V2L has the effect of causing the output of I1 to discharge to GND which is where V2L is driven to by the pulse RST1 at gate input of LBR1. RST1 is asserted concurrently on the gate input of NFET GBR1 to move harvested charge on V2G to the harvesting grid V2.

Now that L_out 712 is discharged and GBE 730 is turned off, GRBL can be precharged to VDD from its partially discharged state from a previous Read access. Once RST1 has moved charge from V2G to V2, RST2 'resets' V2G to GND readying it for the impending Read. Also, since L_out 712 has been discharged during RST1, the NFET GBE is turned off enabling the precharged GRBL to hold its precharge voltage of V_{DD} when V2G is discharged to GND by RST2.

All of the 4 signal outputs shown in Fig 12 are generated off the Block select signal during a Read access in the sequence shown according to when each of the 4 signals are triggered off the Block select path. Systematic variations in Process/Voltage/Temp impact all of these gates in proximity to each other, but design considerations on the pulses from the point of generation to point of use within the block require sufficient width of the pulse. For e.g., the Fast-Slow corner for N and P channel FETs respectively at low T could cause the active high pulse (Resets 1, 2 to disappear. Similarly, Slow-Fast corner for N and P channel FETs respectively at low T impacts the active low pulse (local, global precharge). These and other risks would need to be simulated across all relevant corners to enable robust operation. Random variations in device characteristics are unlikely to be significant since these circuits will not be using small geometry devices.

*4. Immunity to Disturb Current Failure:* The proposed bitpath does not require keeper circuitry found in conventional RF array bit paths to avoid read failure when RWL and WWL concurrently select the same row of bit cells as seen in a conventional bitpath. This is illustrated in the circuit simulations of a conventional bitpath without keeper circuits. Cell noise at node 'BitB' - modeled with a voltage bump at the gate input of NR1, can initiate an unintended discharge of the LBL - as seen in *Figure 13* *1300,* when RWL selects the noisy bitcell. *Figure 13* shows a Read failure occurring when the WL pulse is long enough (and/or if the operating T or voltage or process corner or random VT fluctuations in the Read stack increase read current). The NAND output evaluates incorrectly to V_{DD}, causing the Global Read BL 310 in Figure 3 300 in the conventional 2P RF bitpath to discharge when the LBL 306 voltage drops below the logic threshold of the NAND. The 'keeper' solution 316, 318 used by conventional RF arrays that avoids the above disturb current failure, however, increases the WL select →G_out delays by over 20% [23].

When using the proposed bitpath circuits, keepers are not required since the rising voltage on V2L 738 due to noise voltage at the gate of NFET NR1, self-disables the discharge of the LBL 706 as V2L asymptotically approaches the noise voltage (*Fig 14*). The LBL 706 and GRBL 710 can thus be seen in *Fig 14* as maintaining their precharge state of V_{DD} or close enough to V_{DD} without evaluating incorrectly as the conventional 2P RF array would in the scenario described above

*5. Leakage reduction:* *Figure 15* 1500 shows the dominant leakage path schematic for a conventional 2P RF column of bitcells and the leakage path schematic for the proposed 2P RF column of bitcells assuming the same number of bitcells per local bitline. In both cases, the read stack dominates the leakage from a bitcell since the read stack devices are typically higher performance than the other bitcell devices. The conventional bitpath has as many leakage paths (1502 in Figure 15 1500) as bitcells that share the local bitline whereas the proposed bitpath has only one leakage path 1504 in Figure 15 1500 through the local bitline reset device LBR1 7 52 in Figure 7 700. *Figure 16* 1600 shows the leakage current from a bitcell column as a function of the number of bitcells per column. The proposed bitpath leakage remains unchanged since the number of leakage paths are fixed and they are independent of the number of bitcells per local bitline.

### Appendix

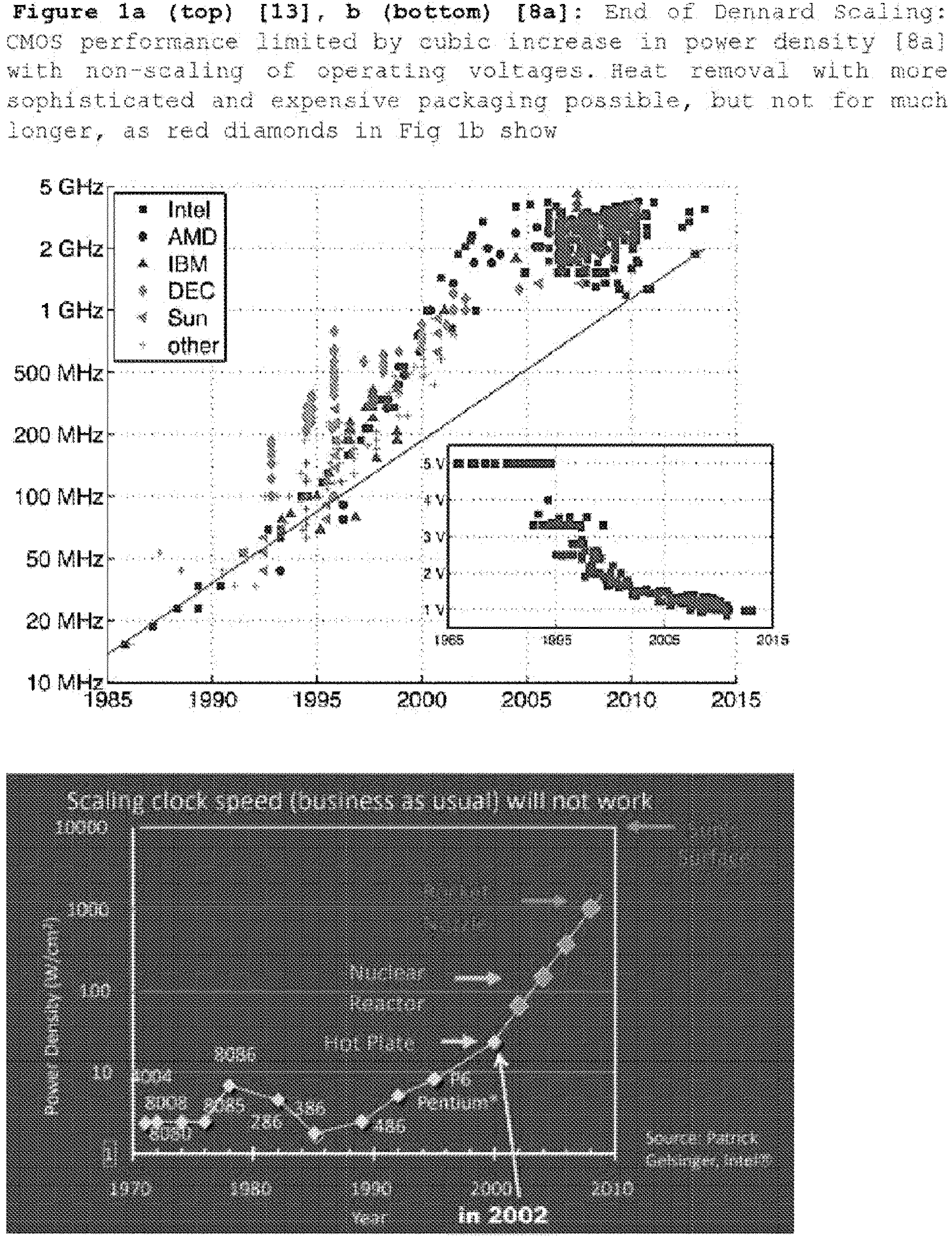

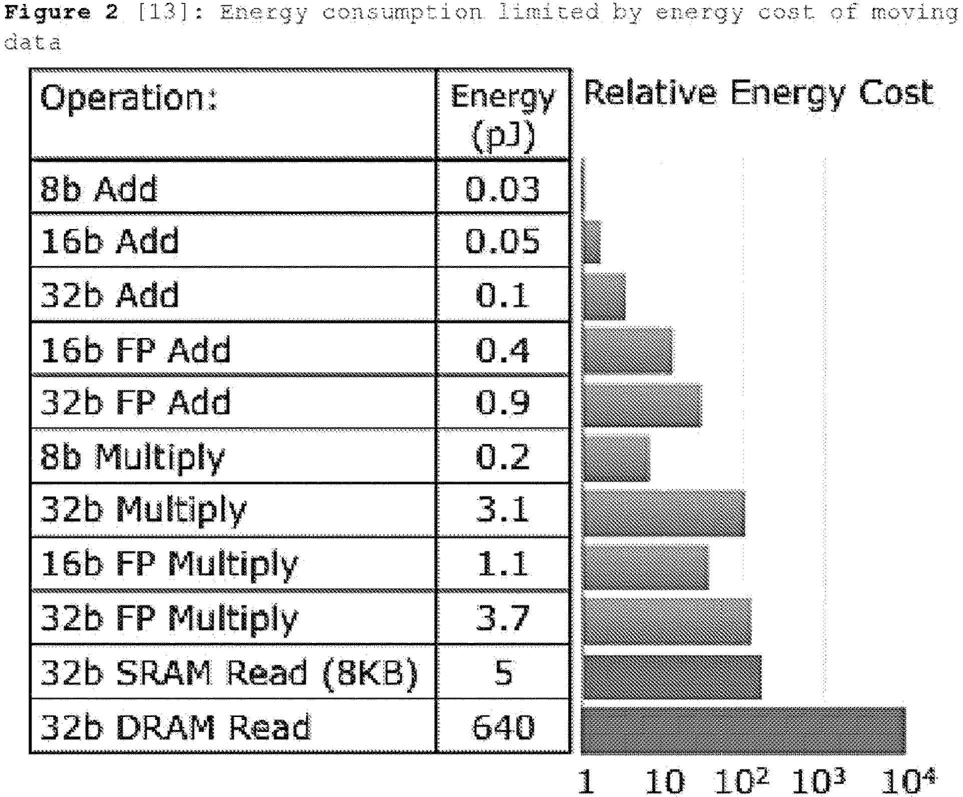

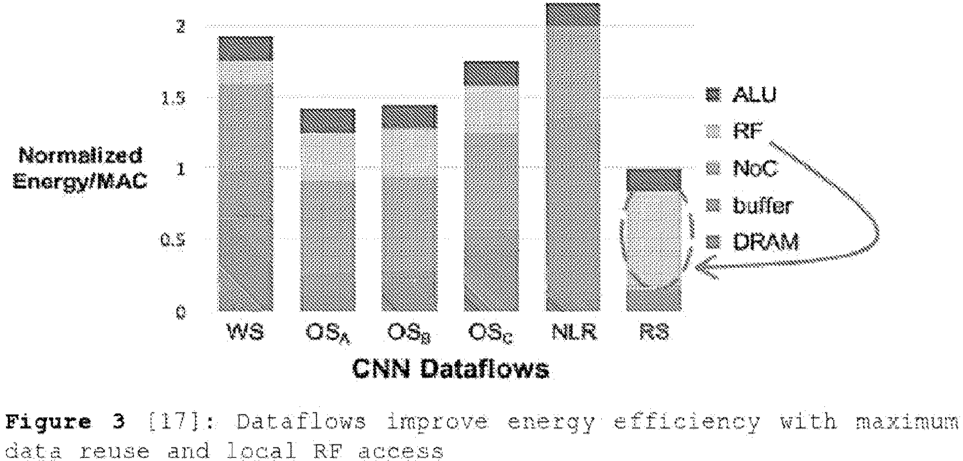

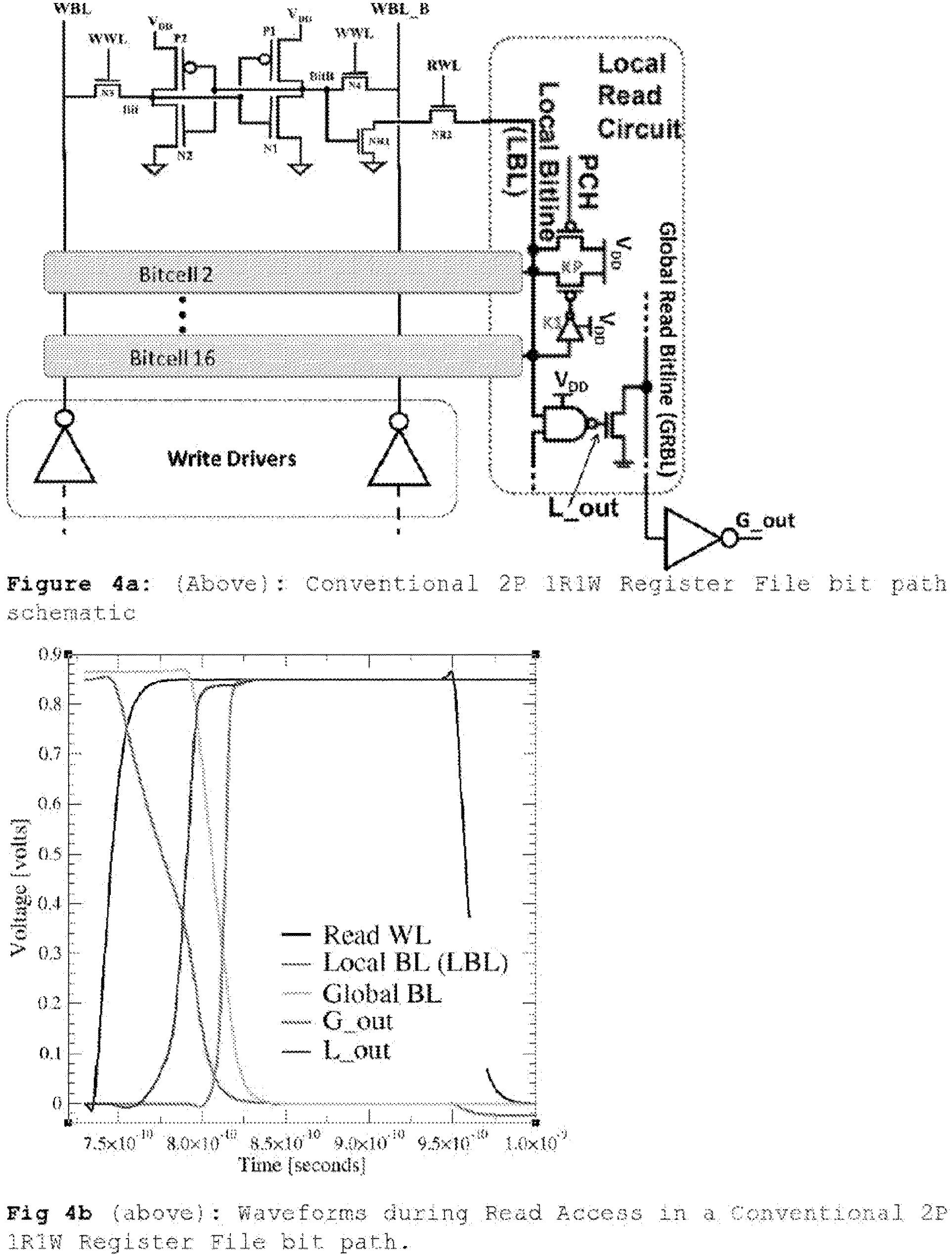

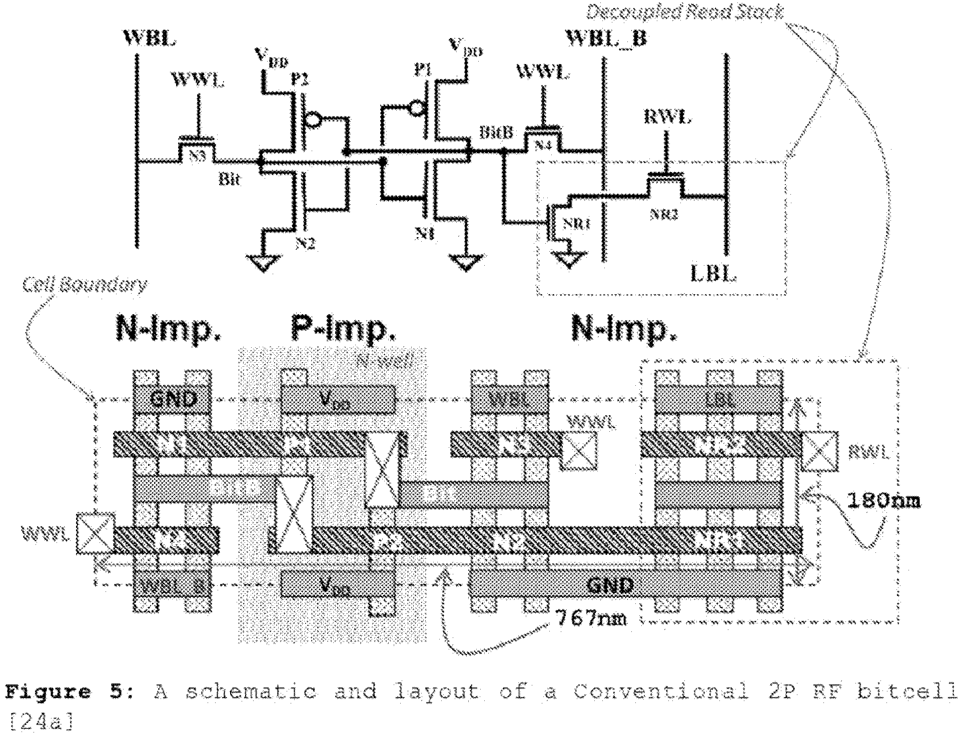

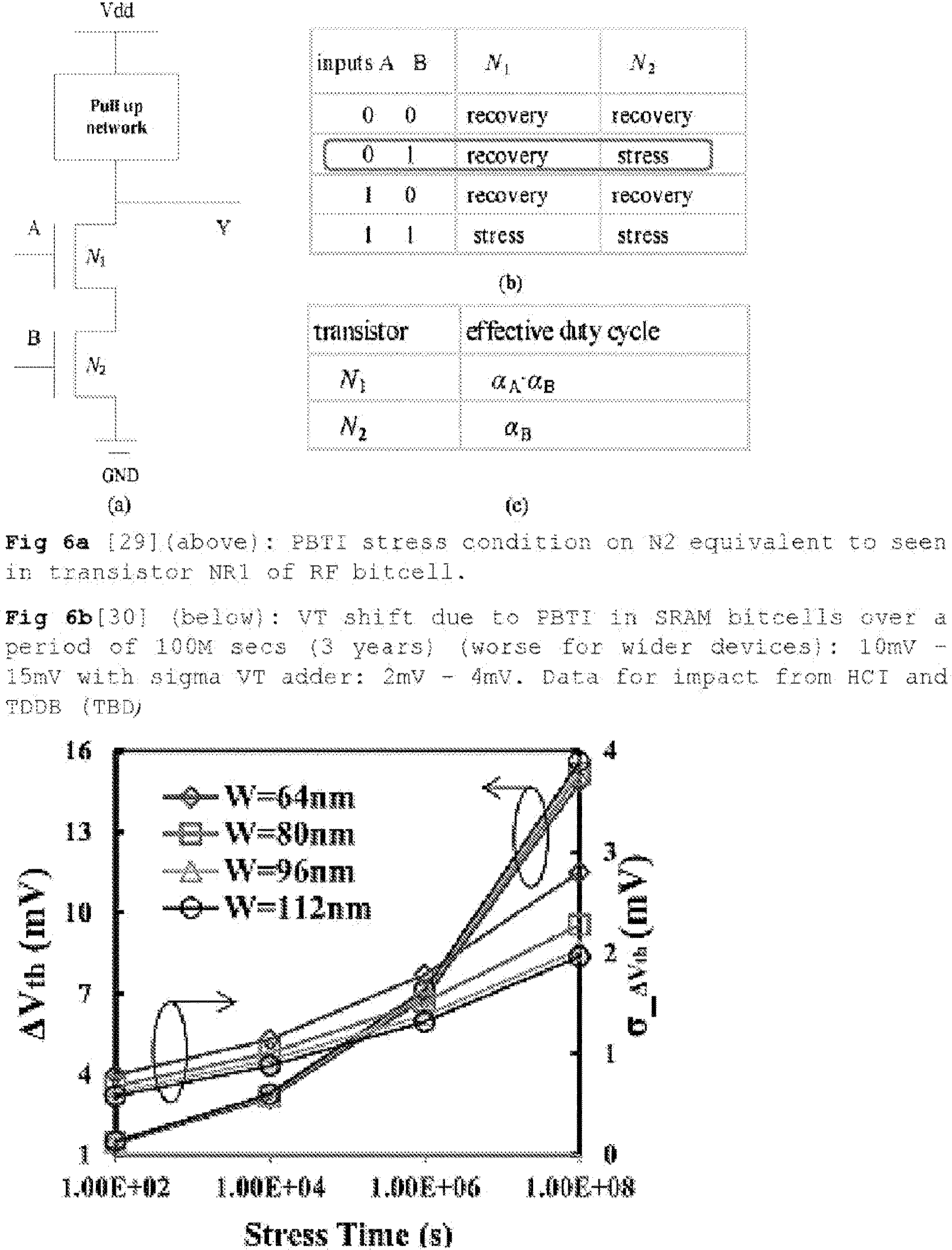

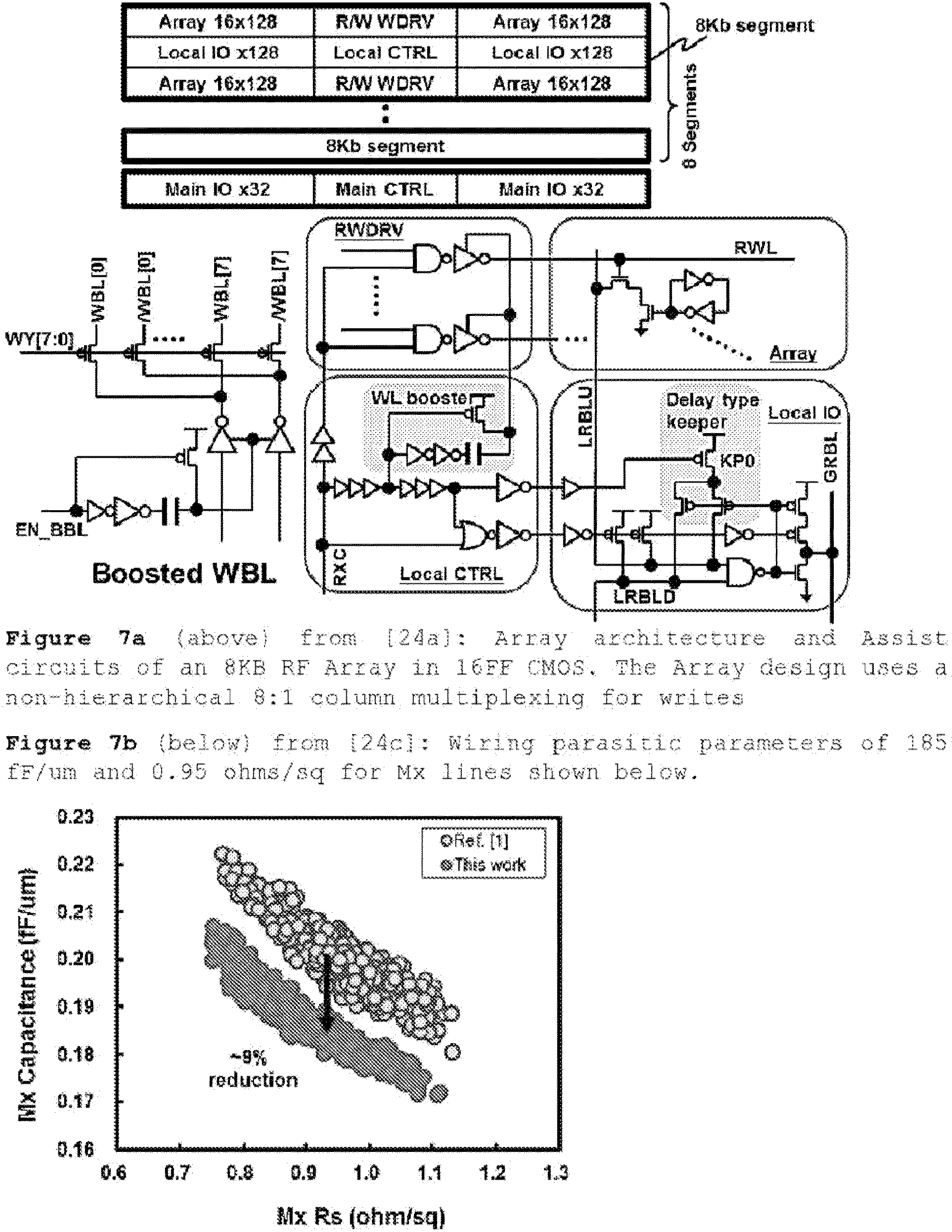

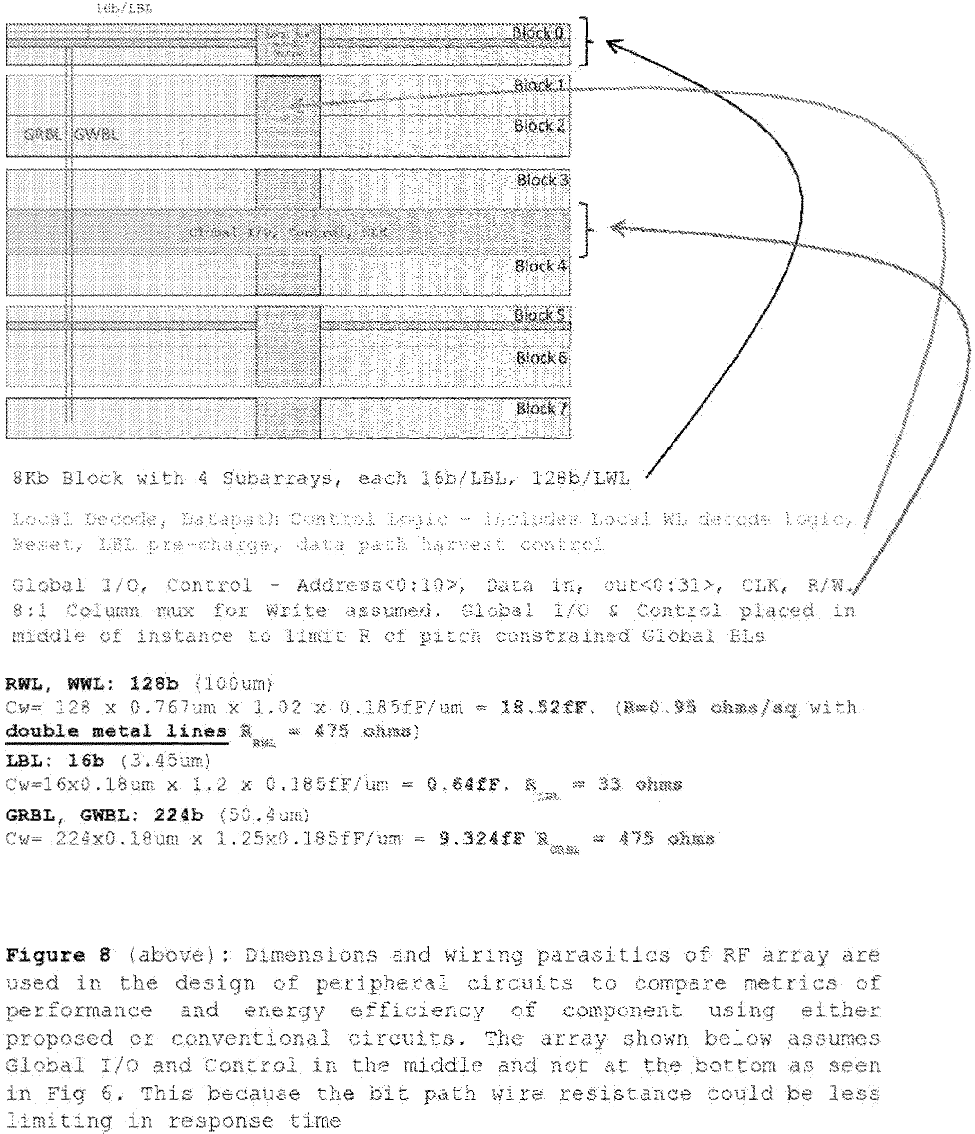

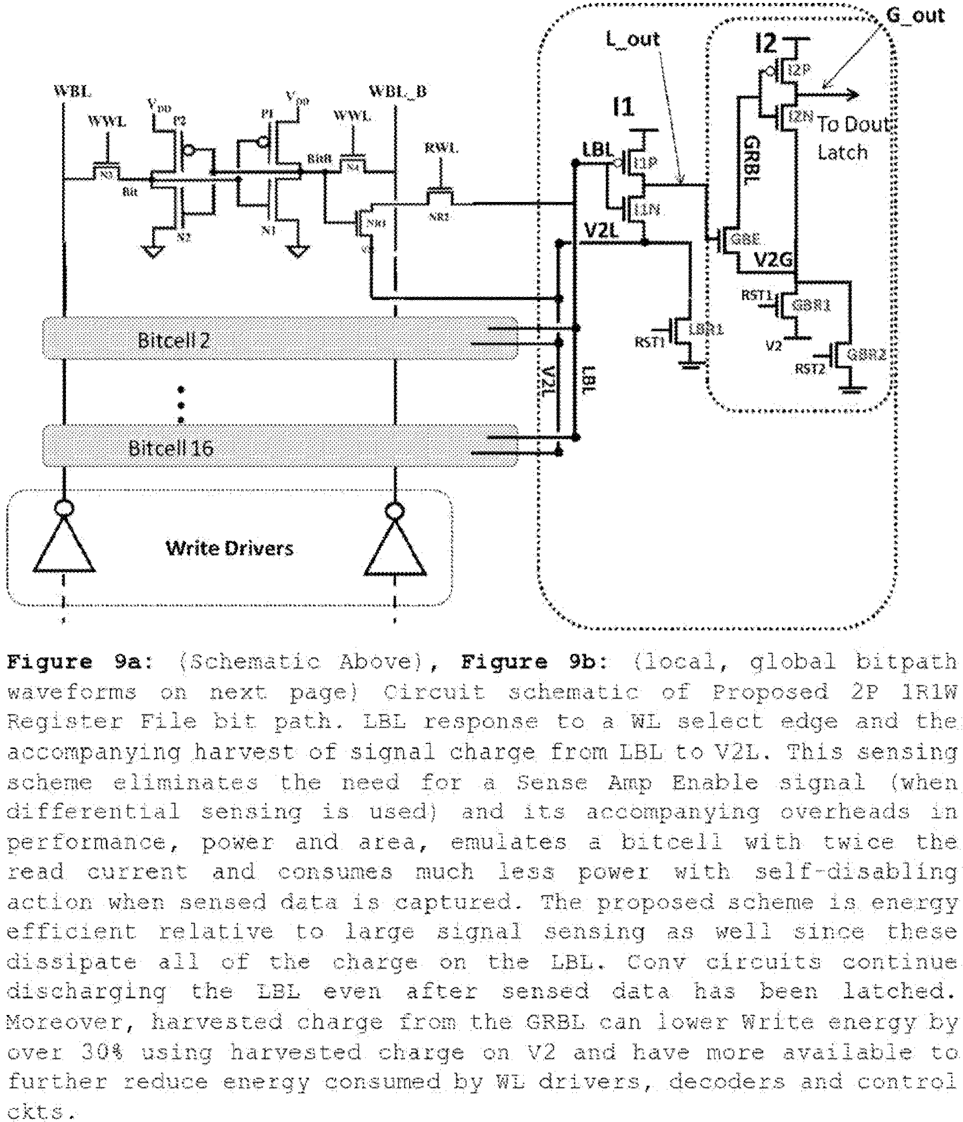

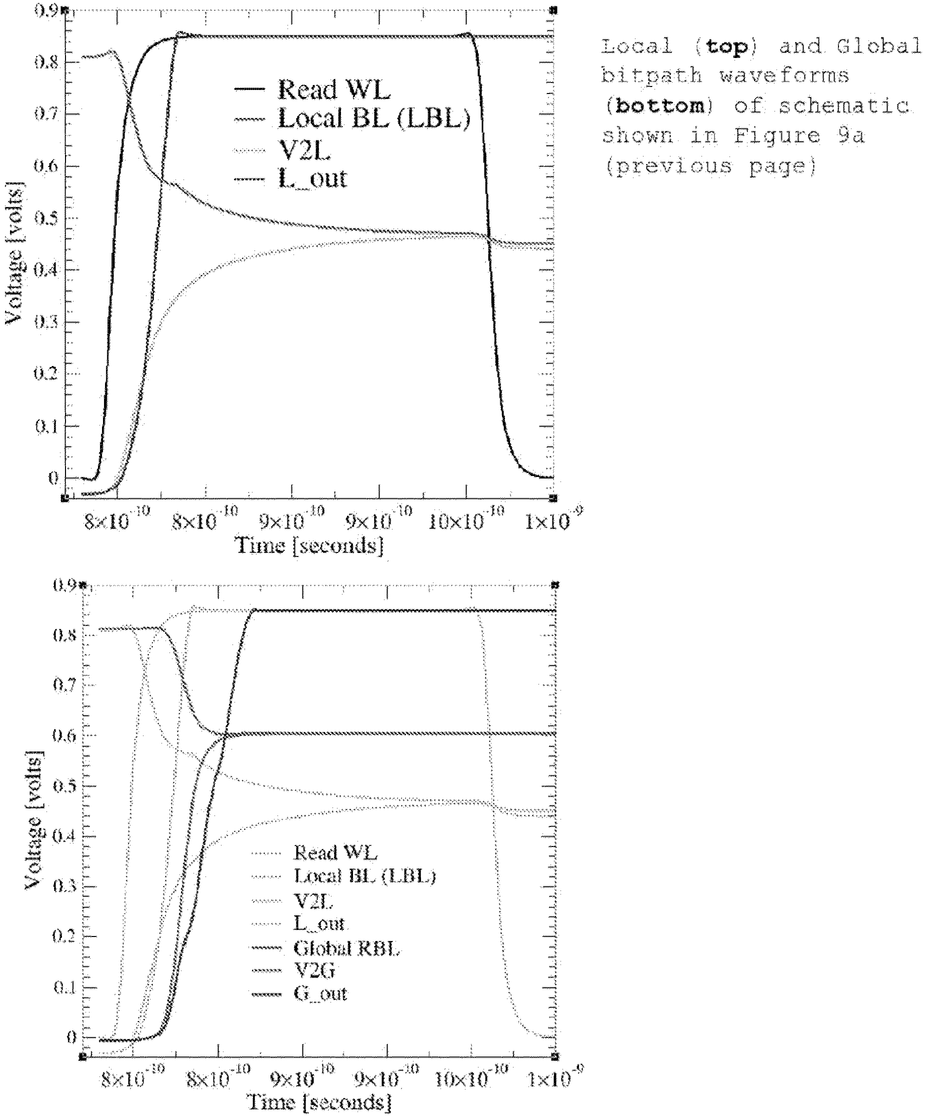

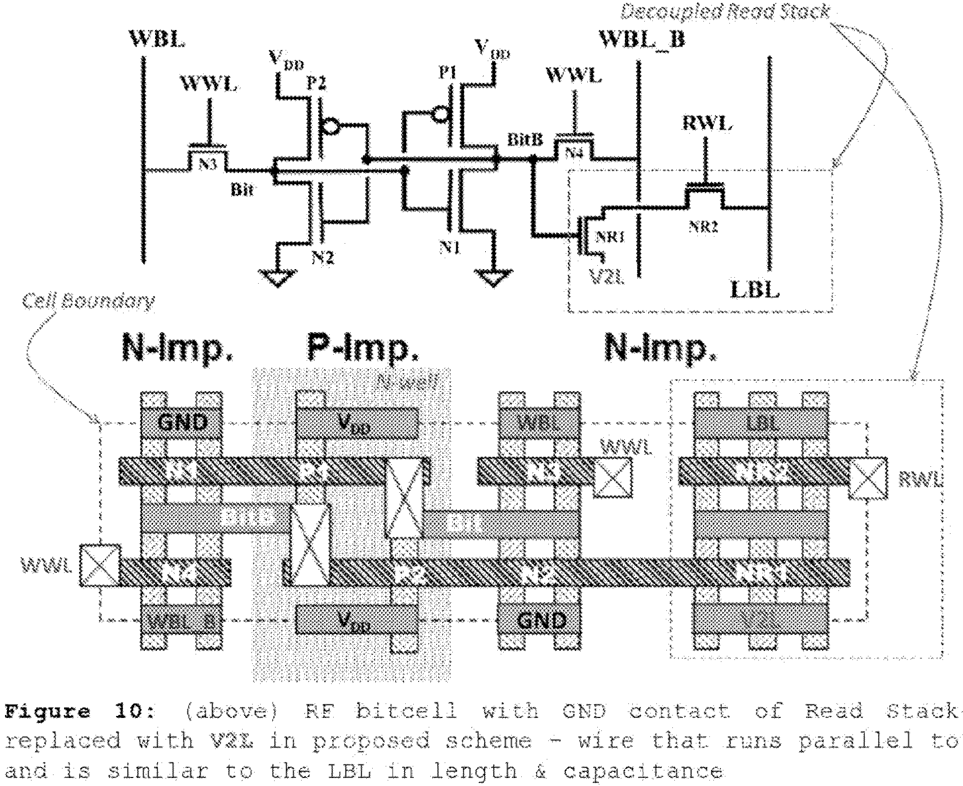

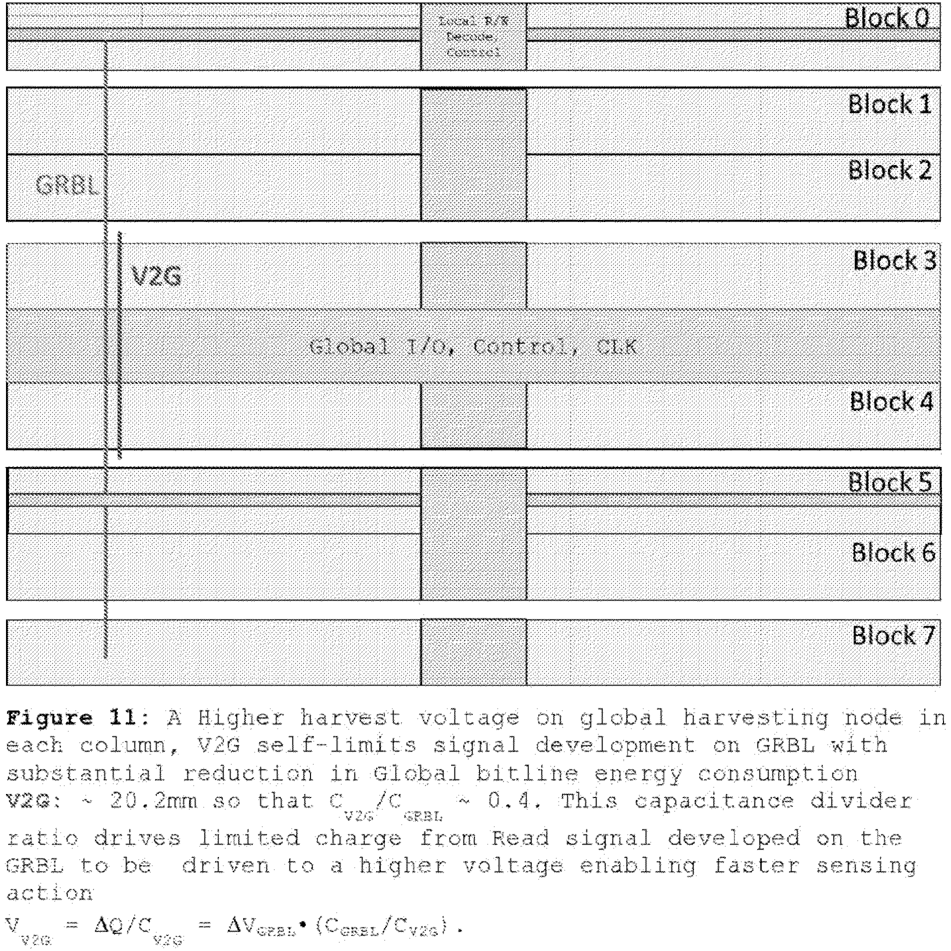

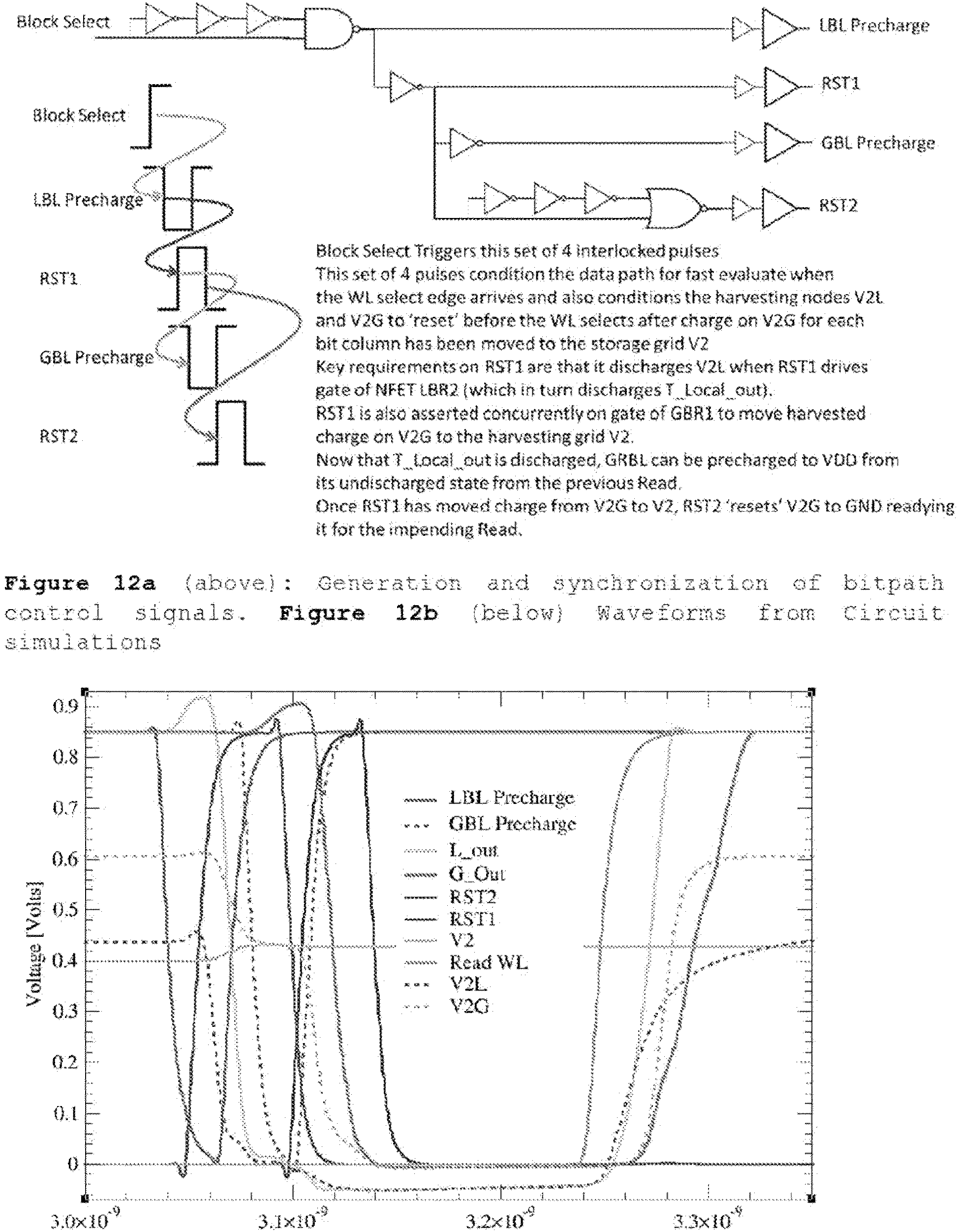

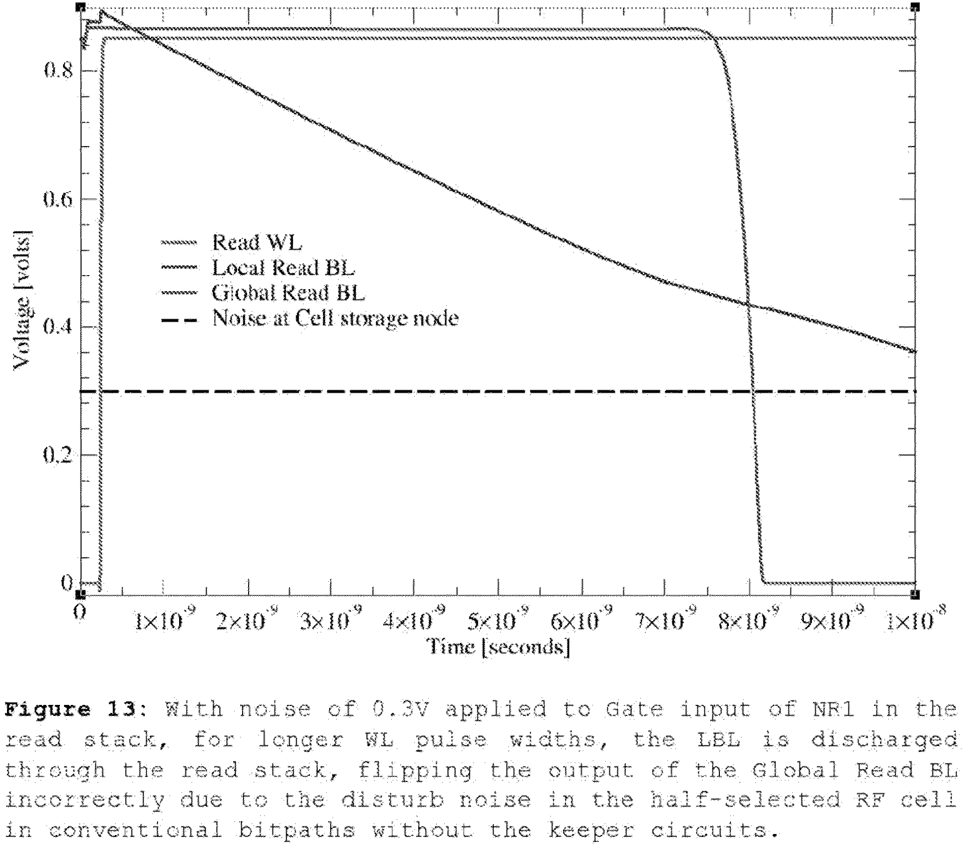

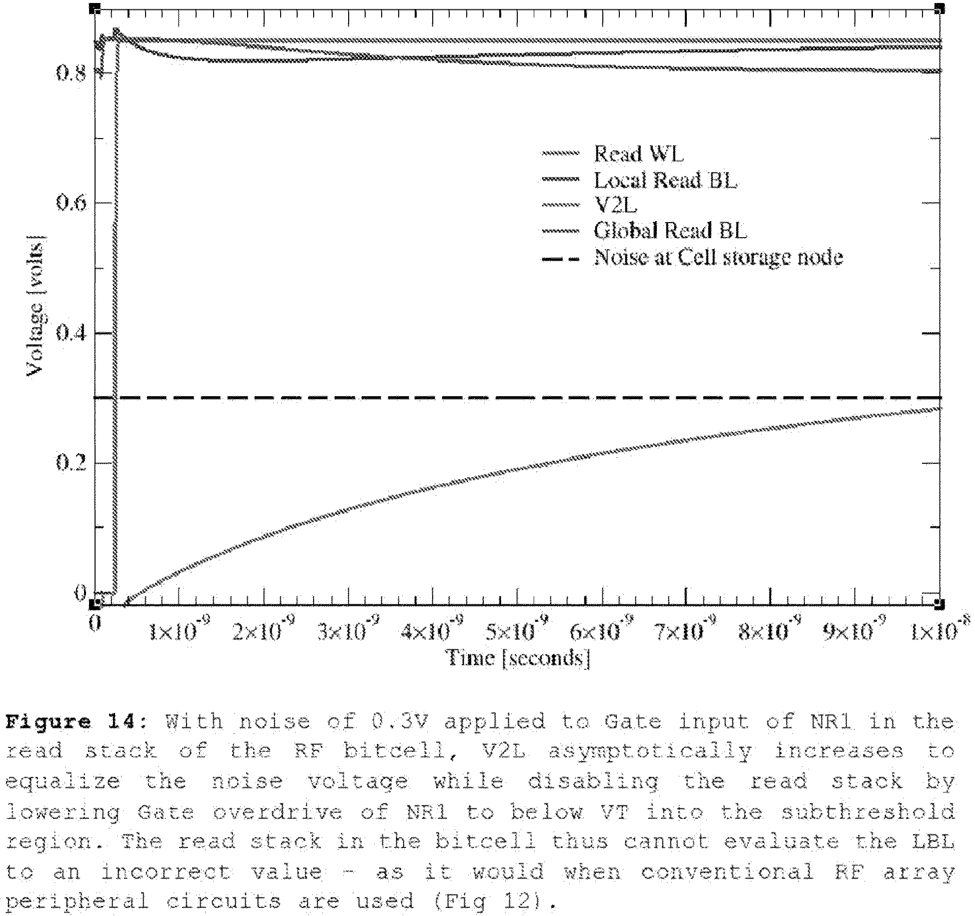

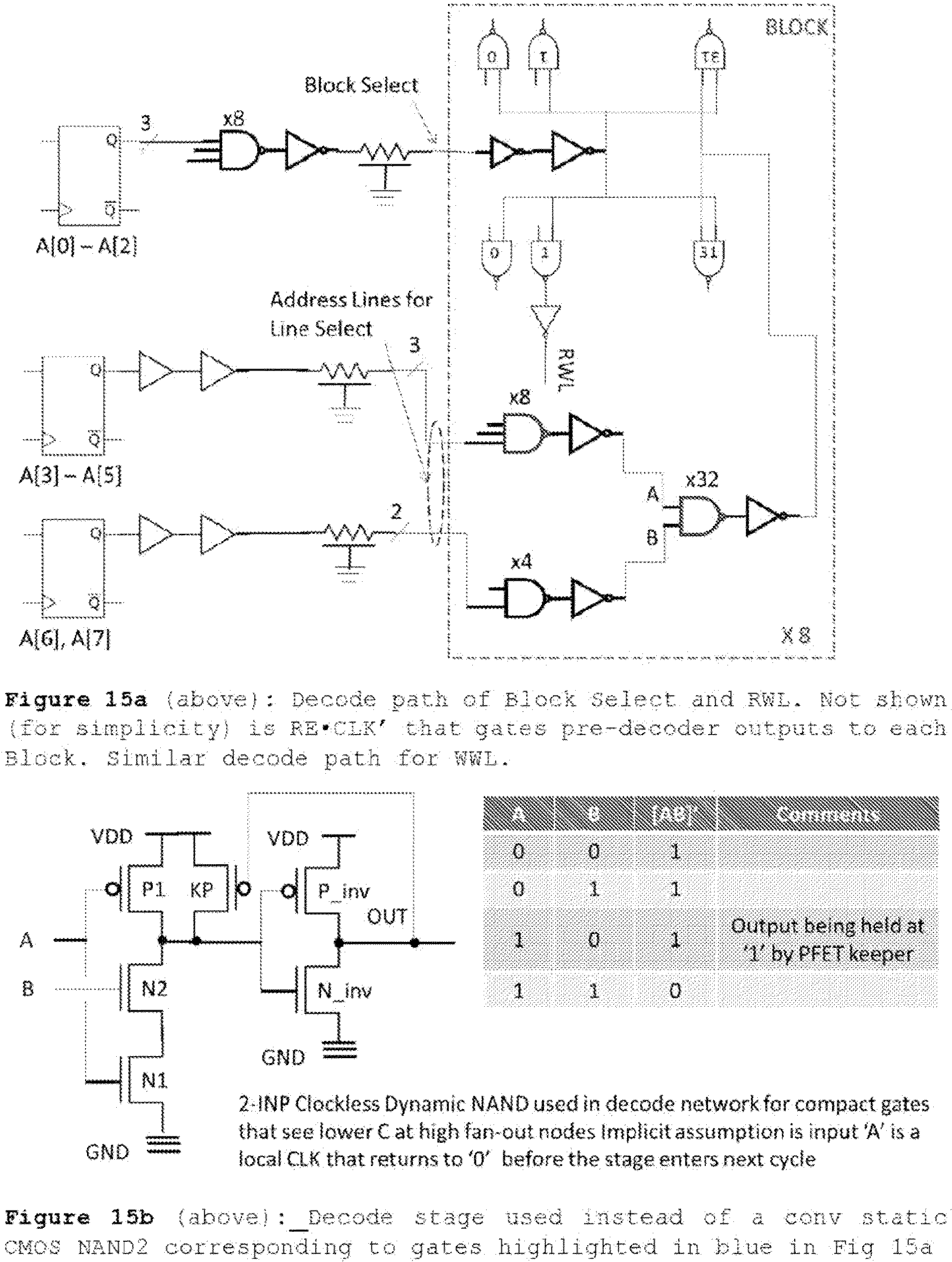

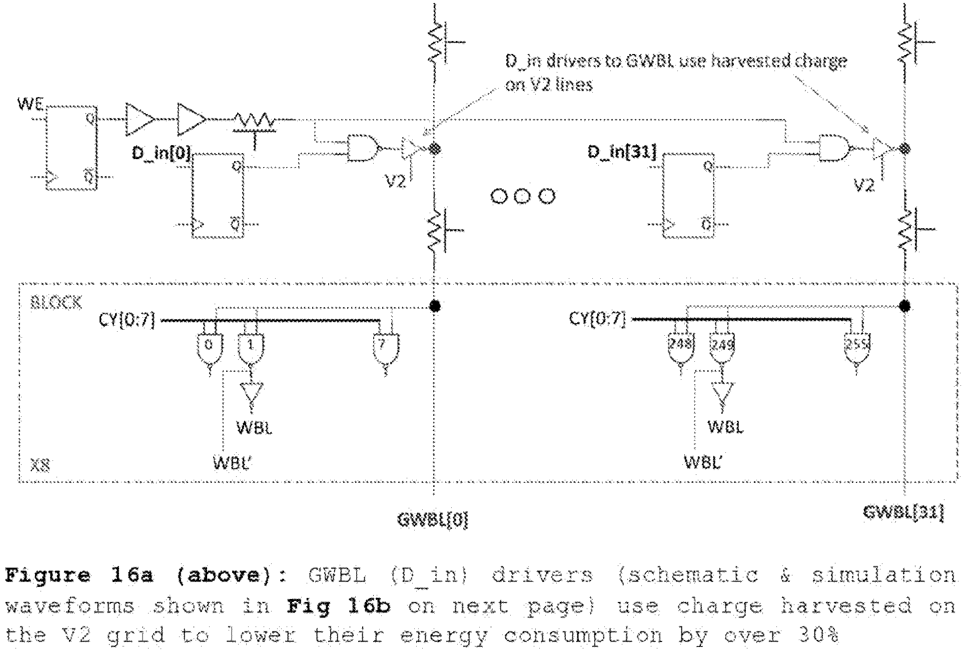

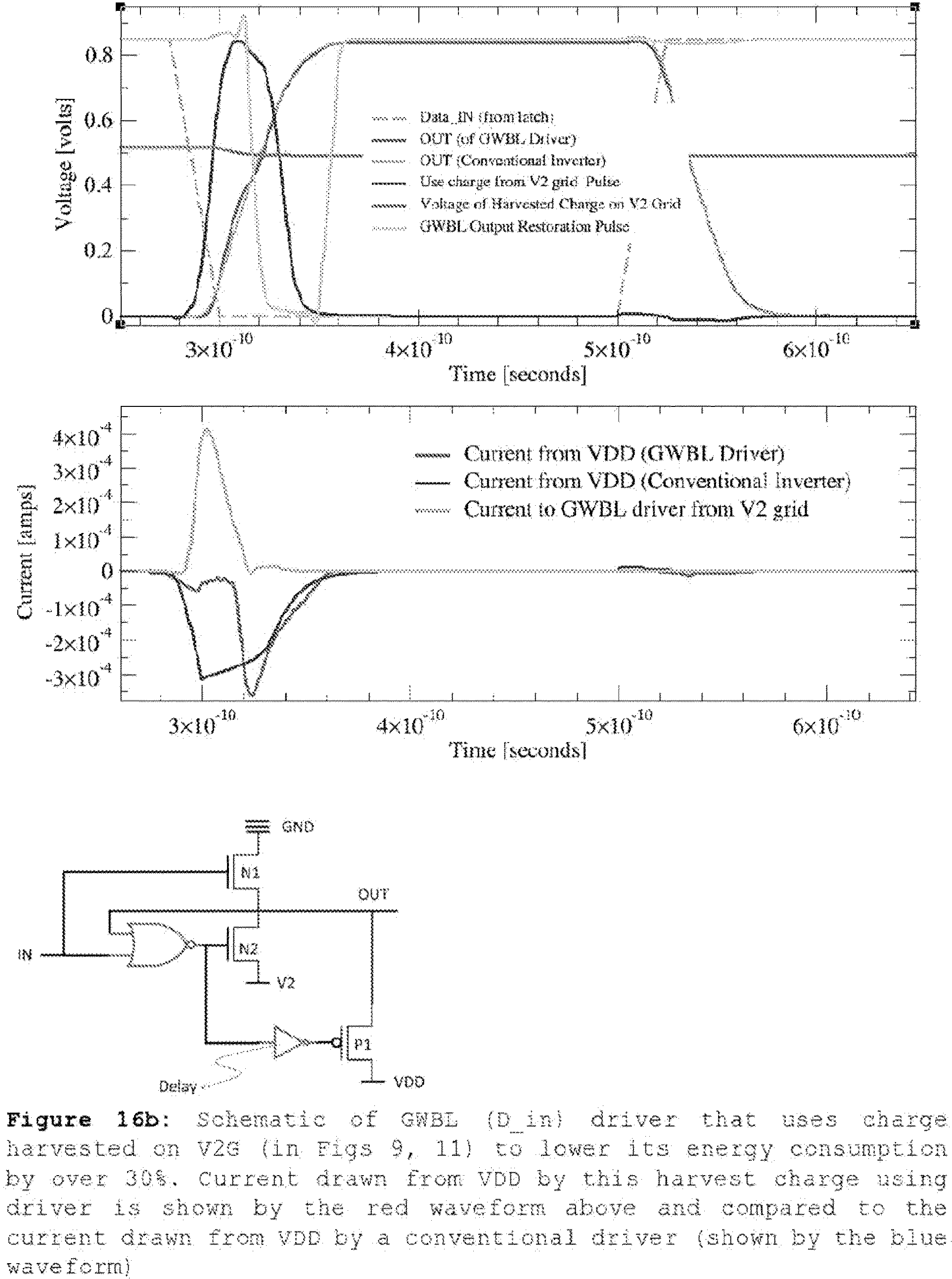

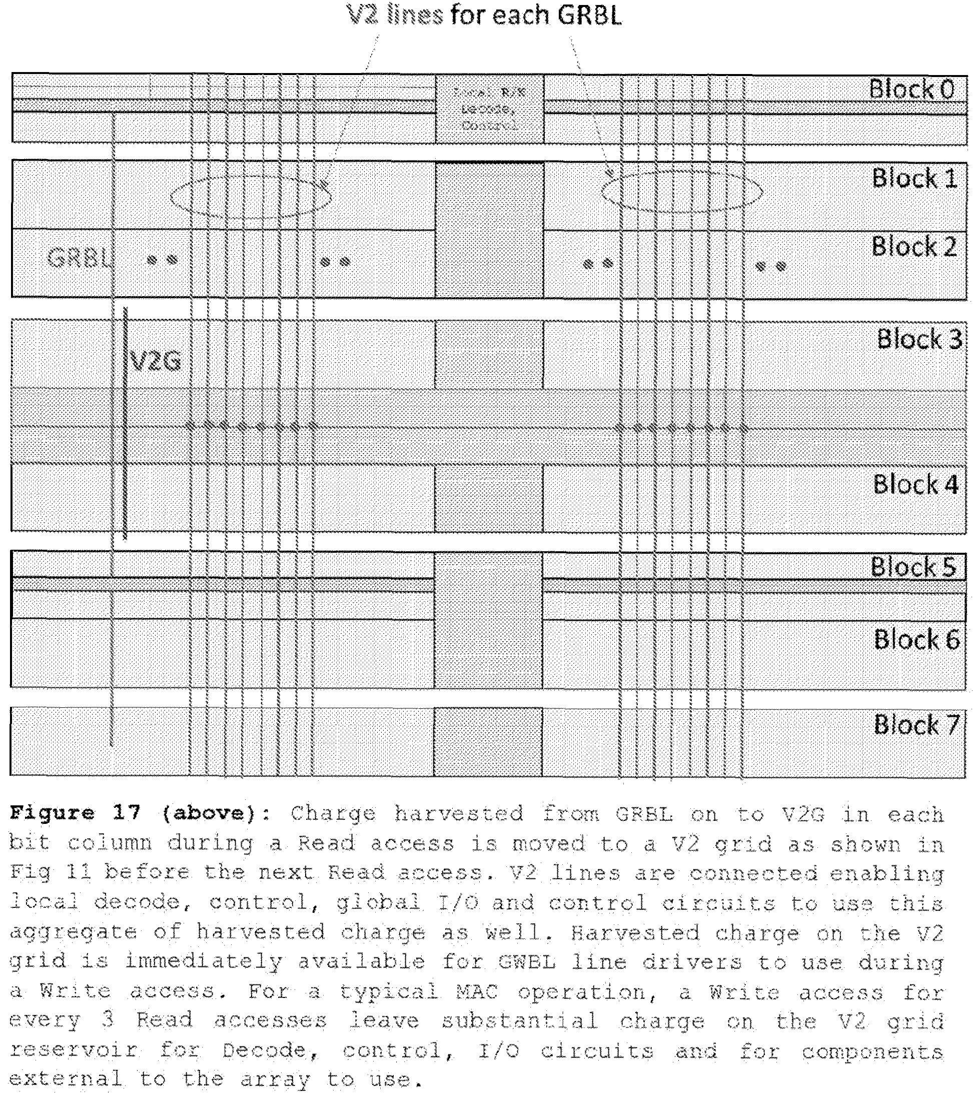

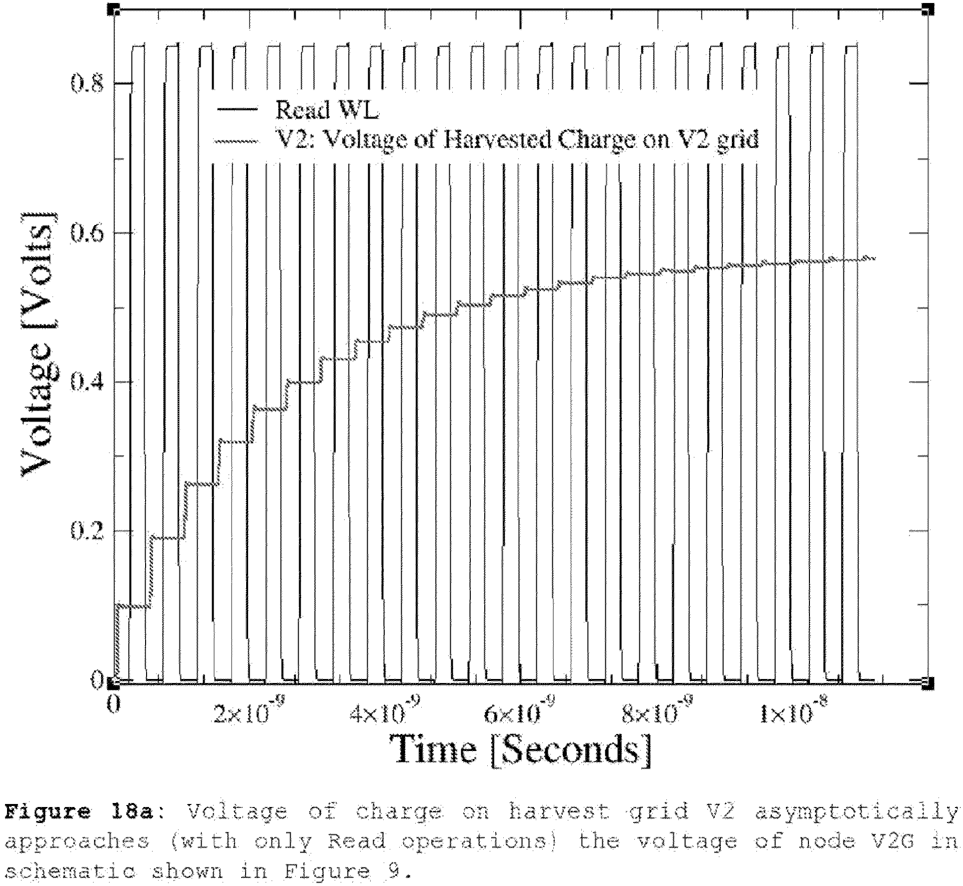

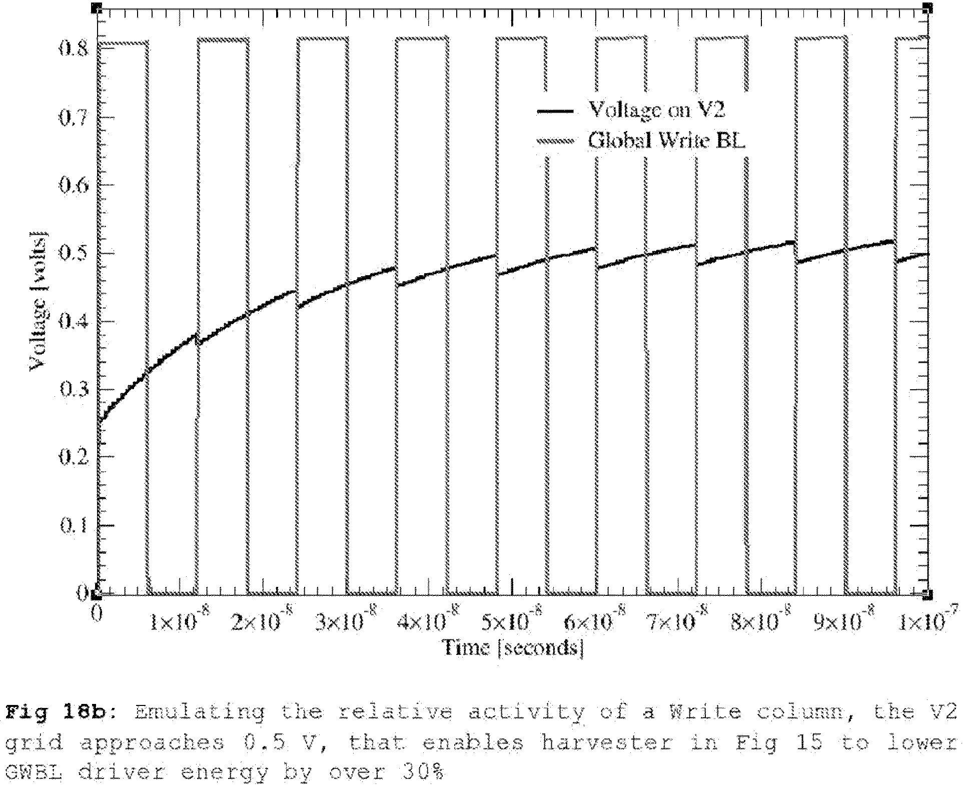

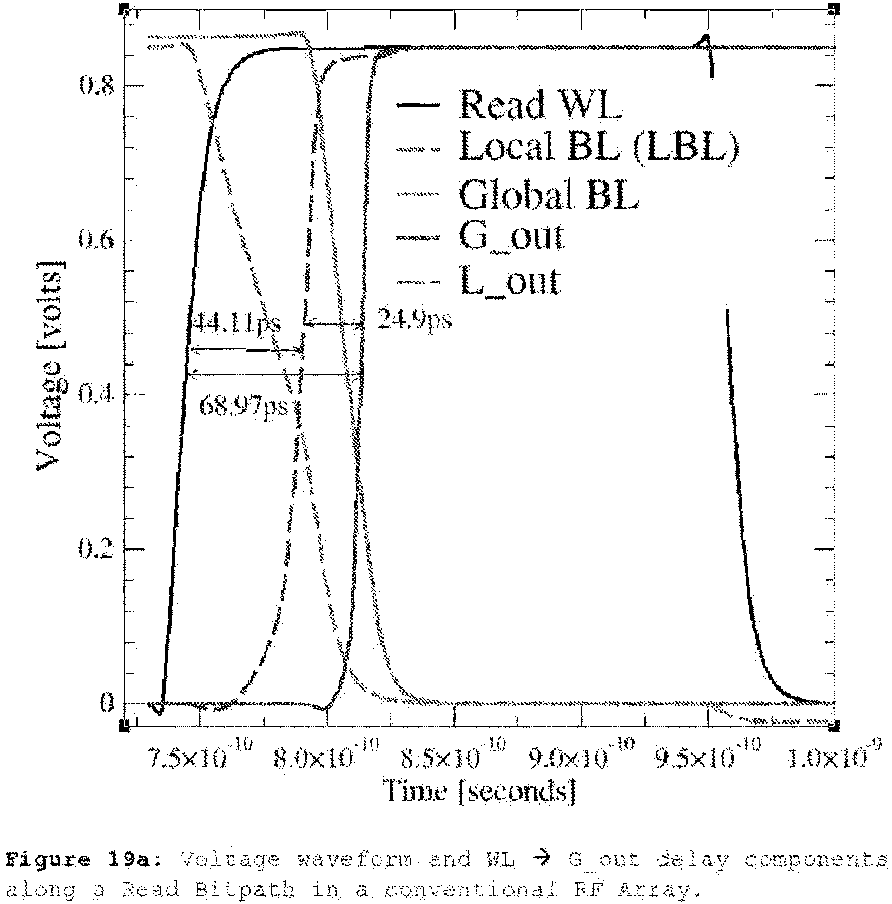

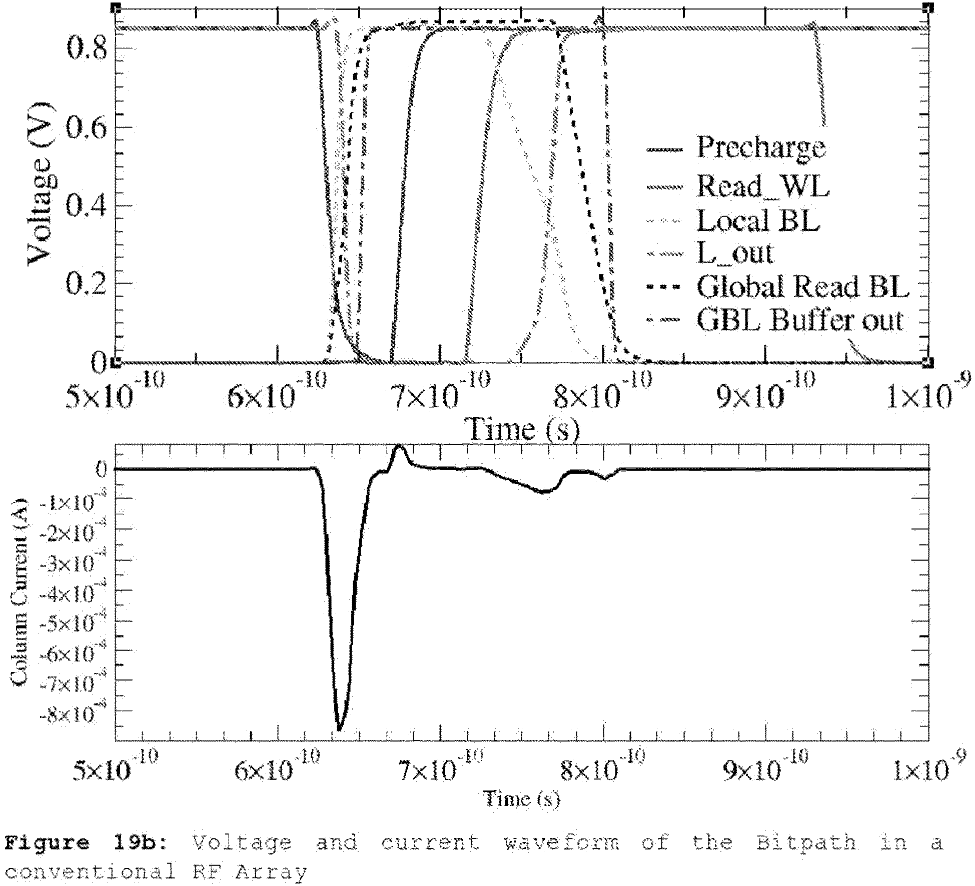

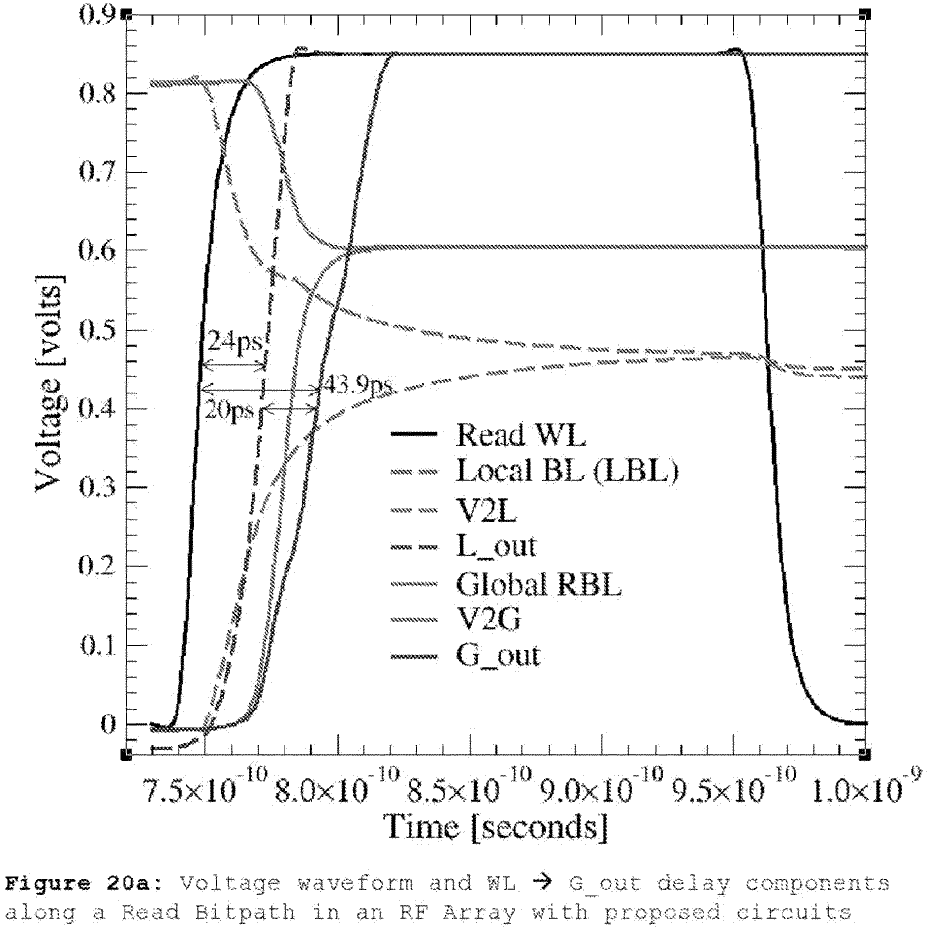

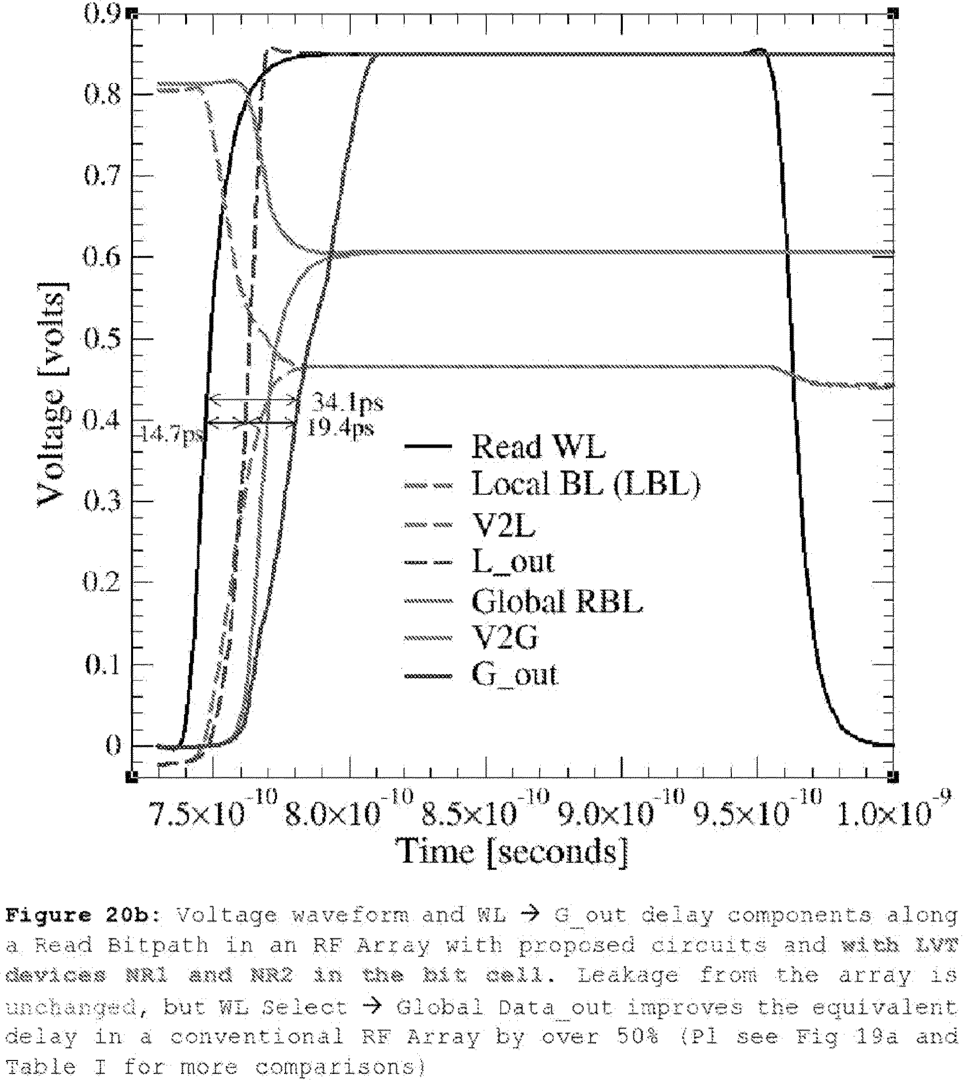

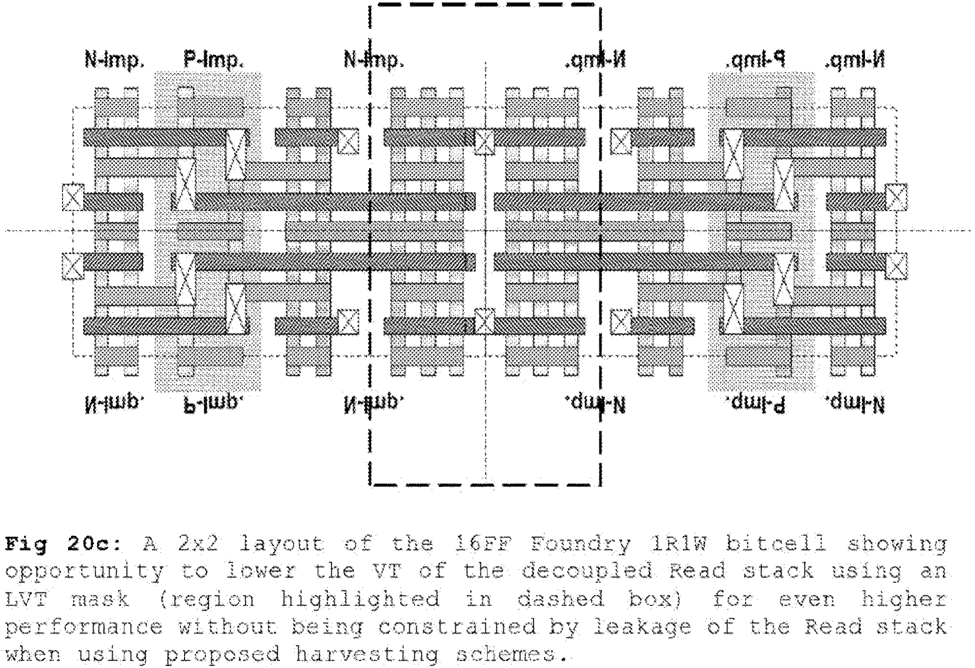

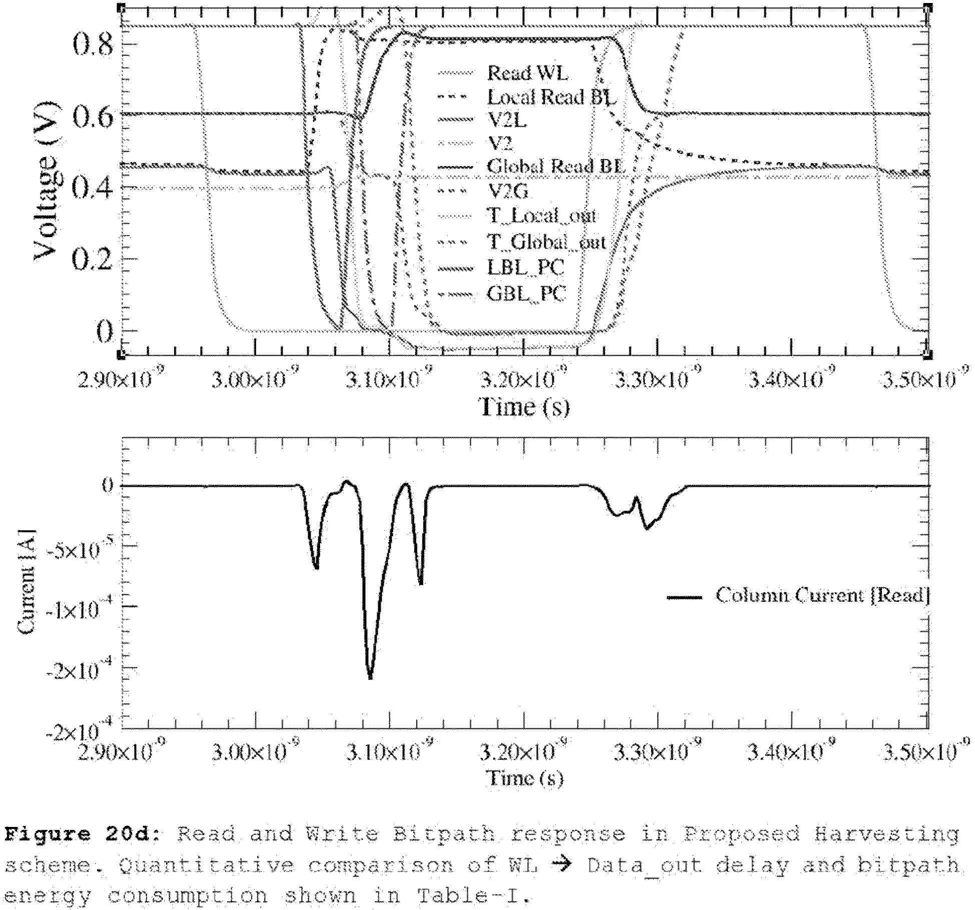

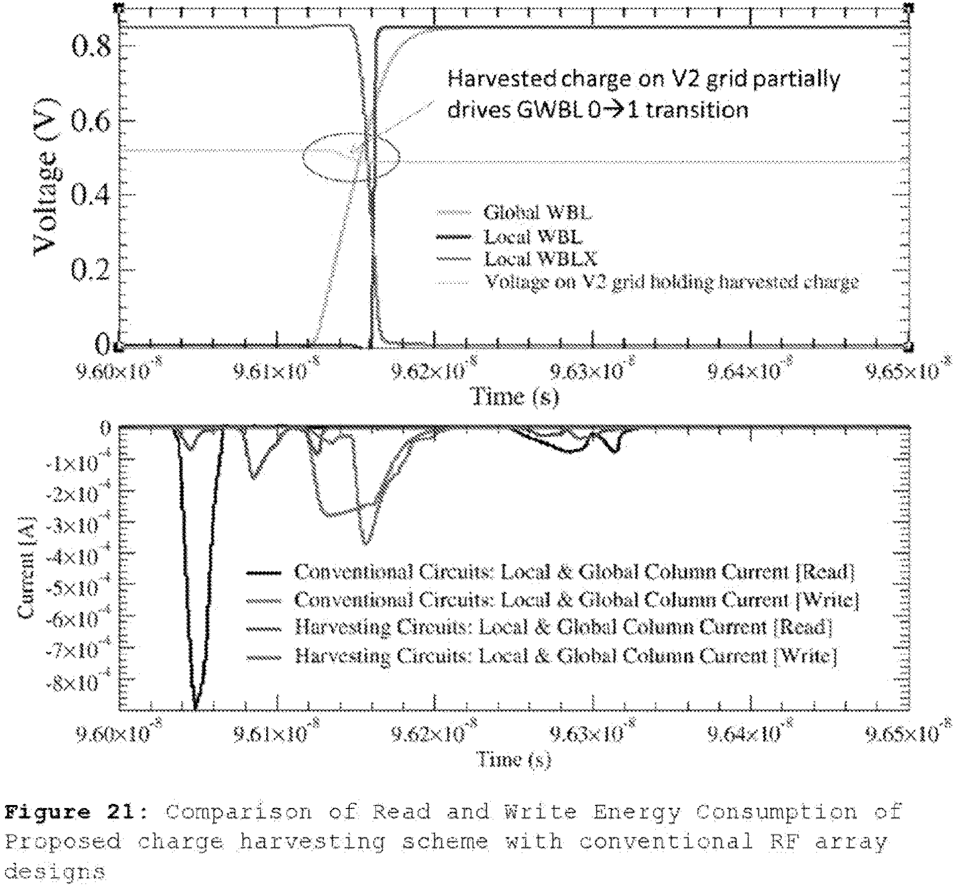

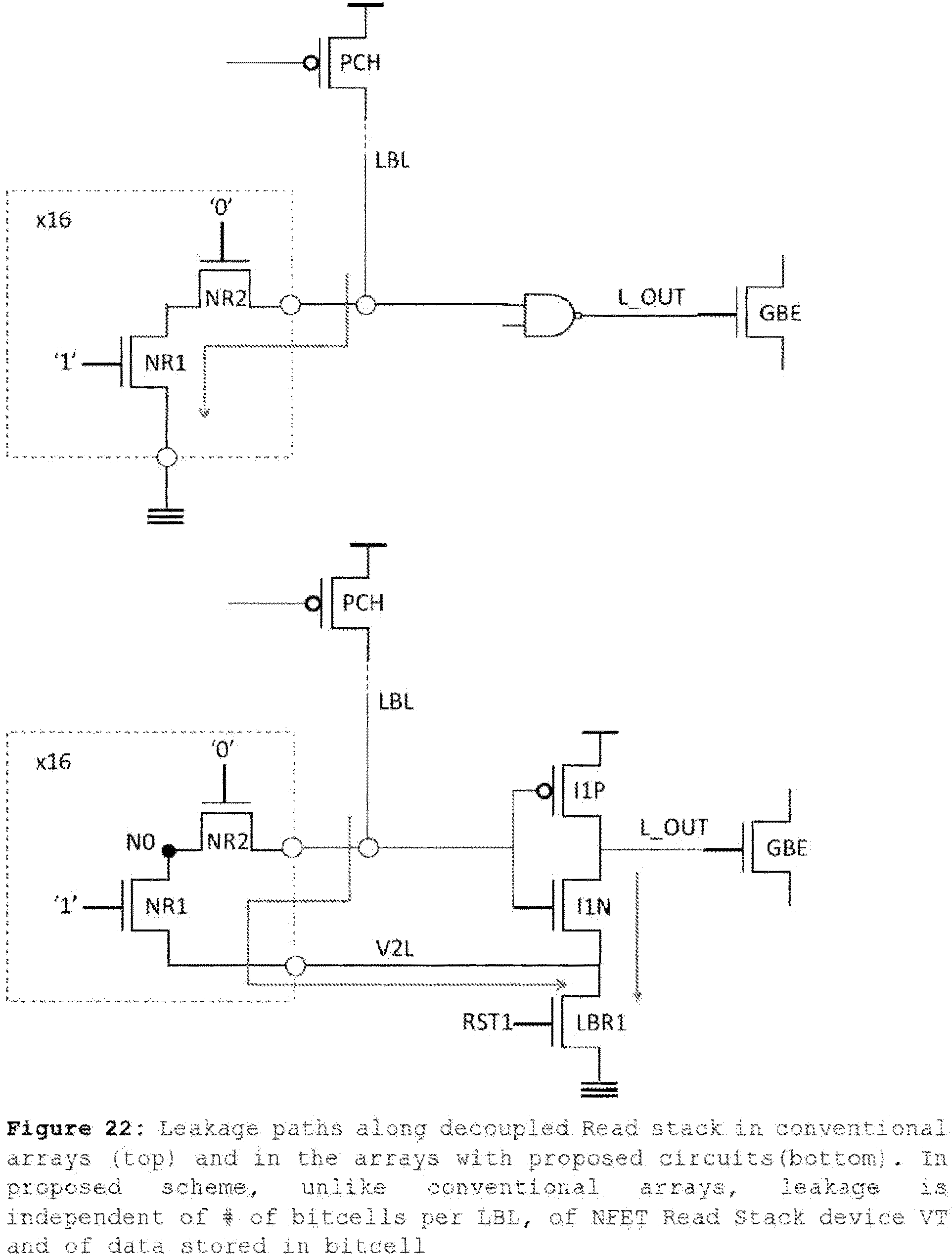

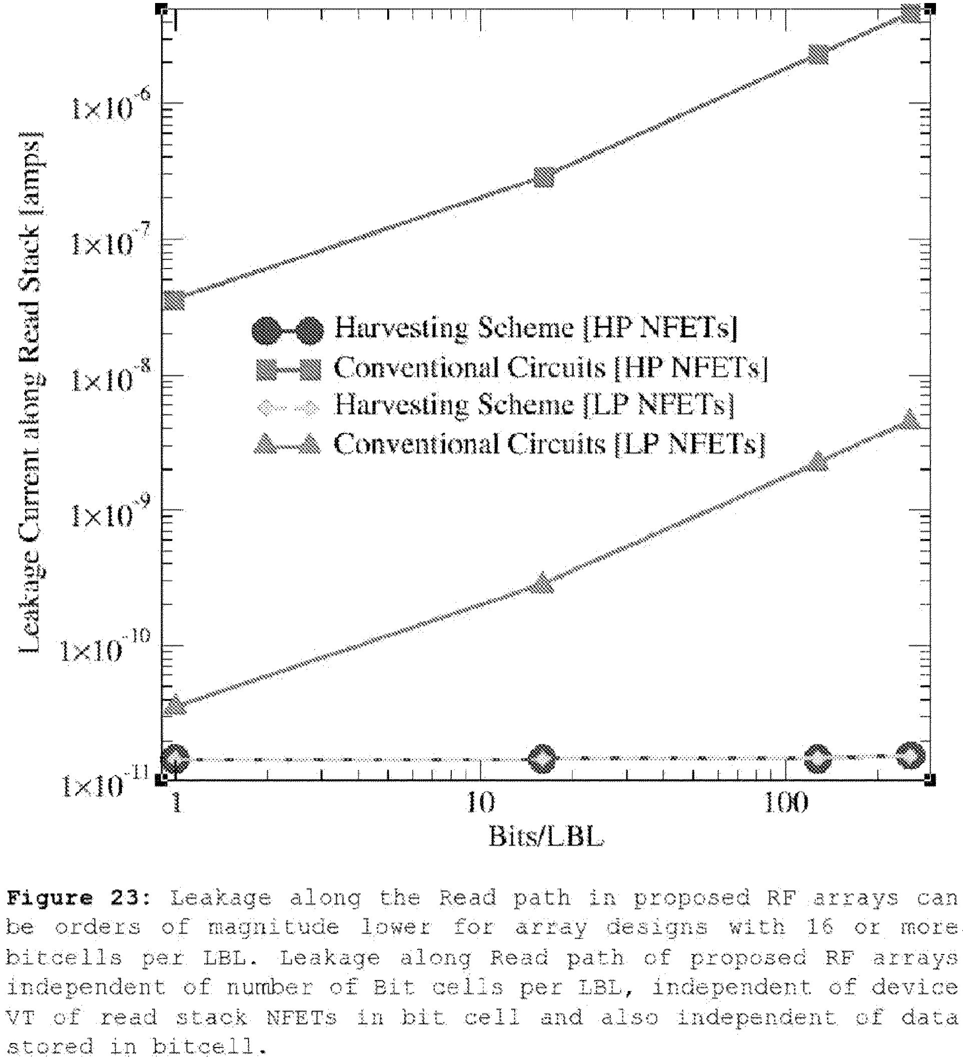

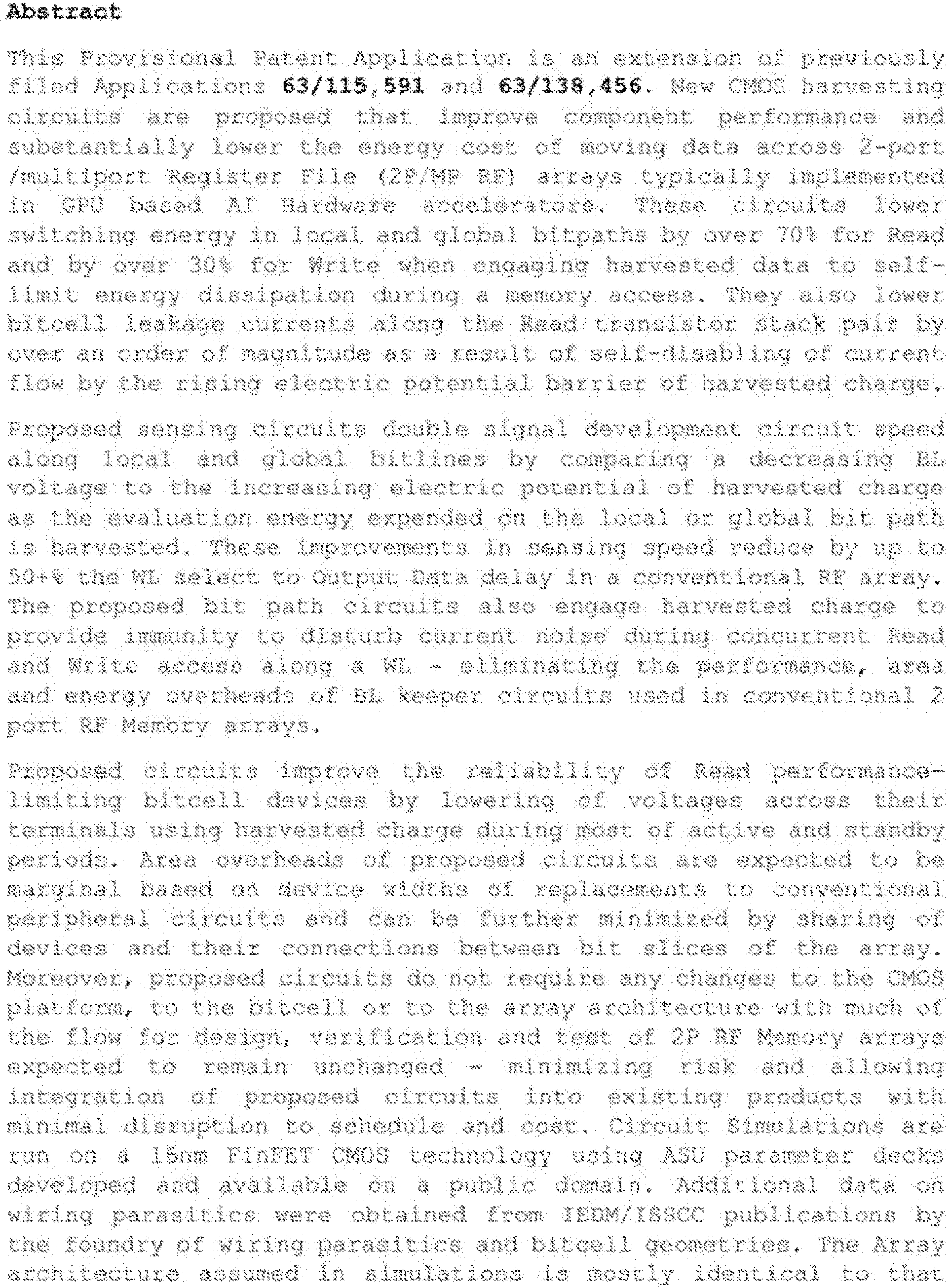

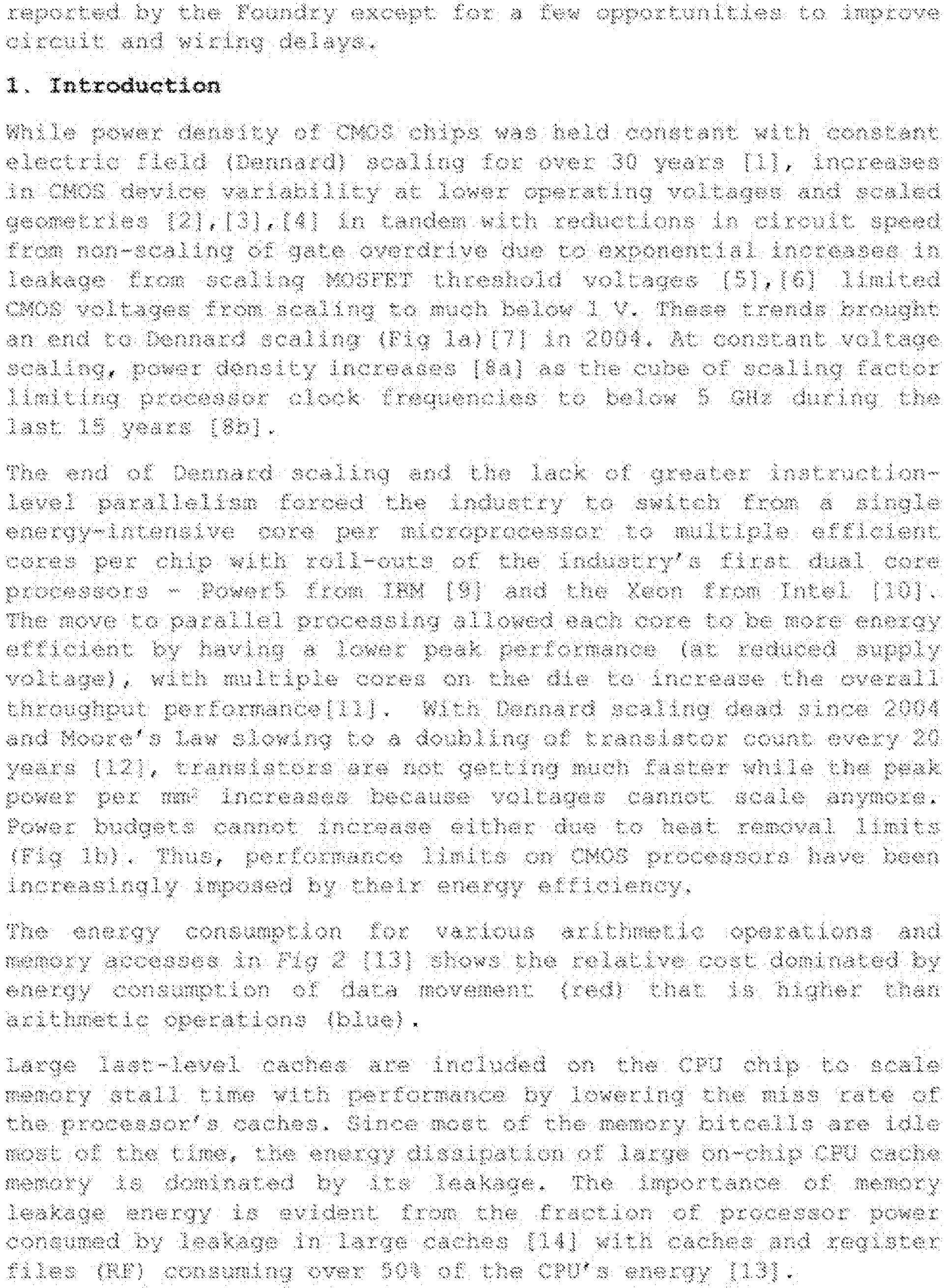

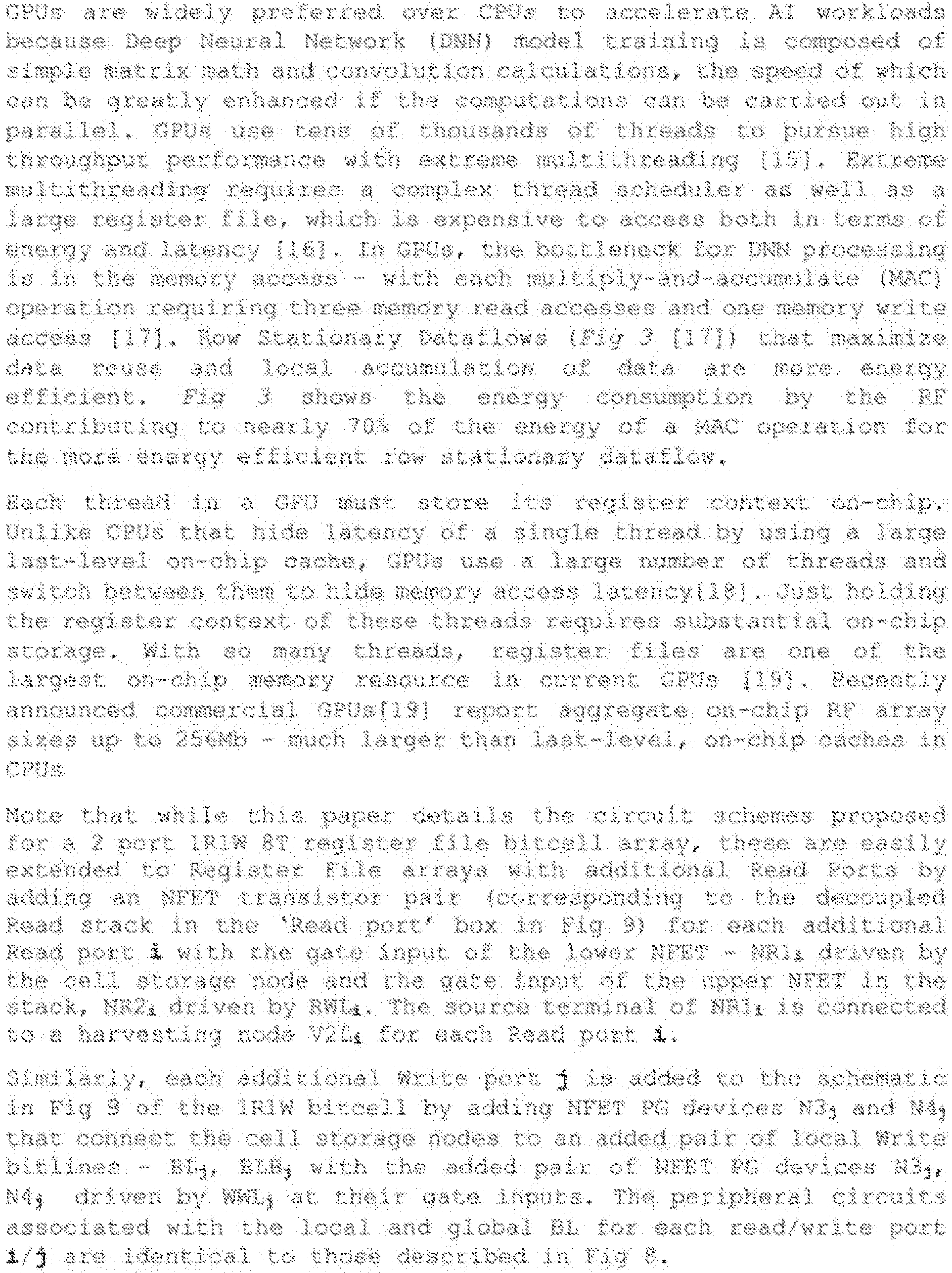

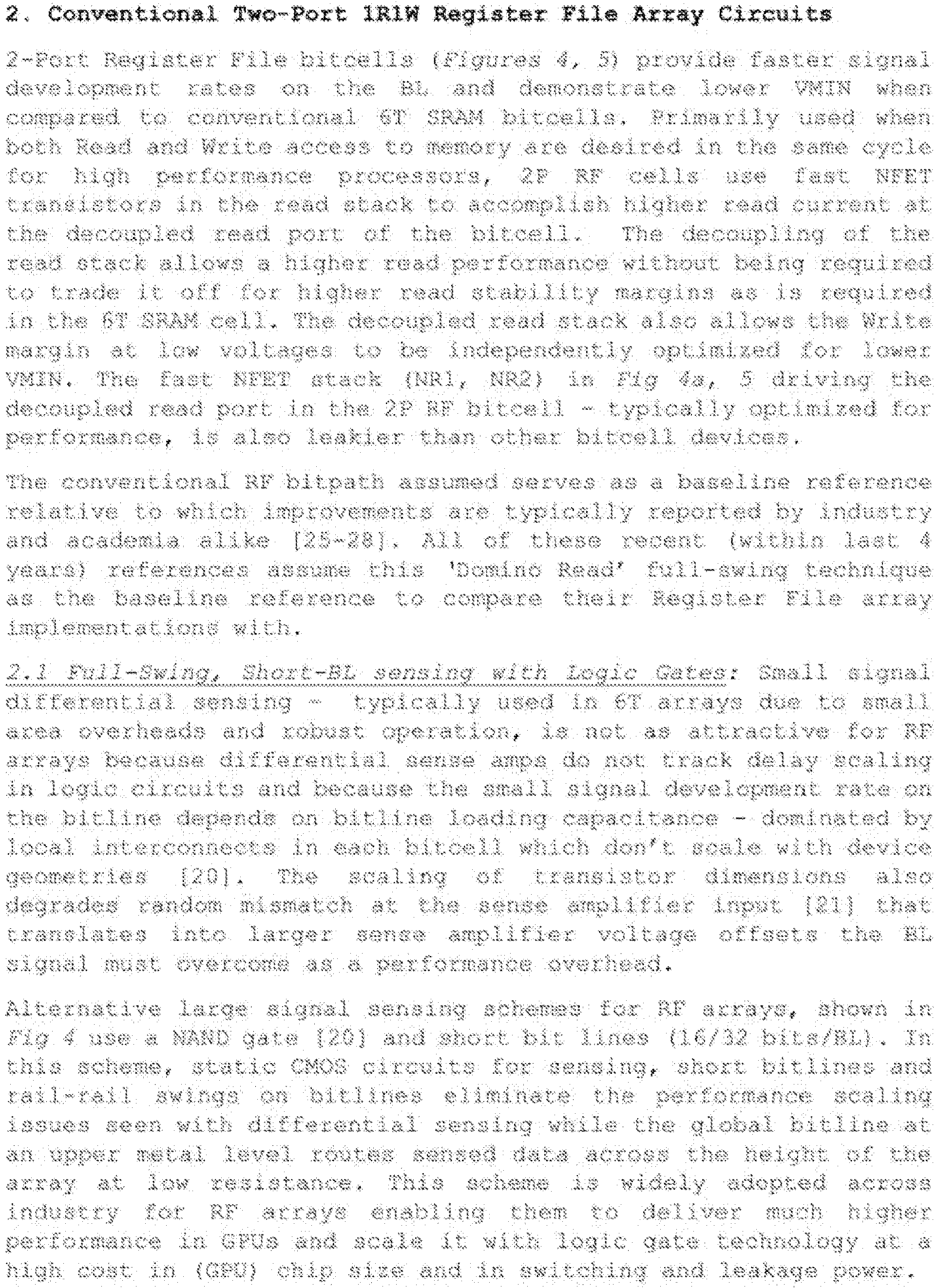

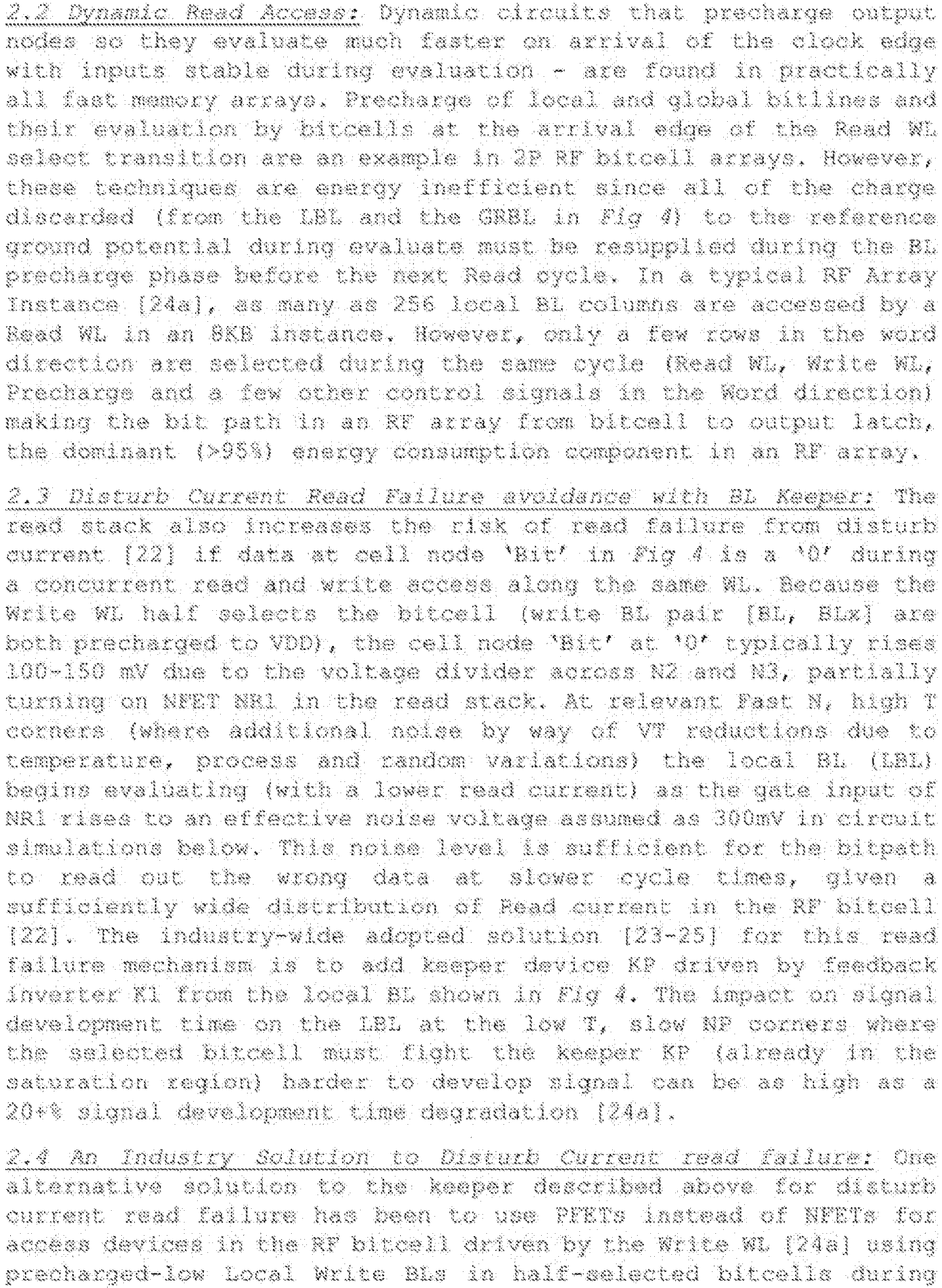

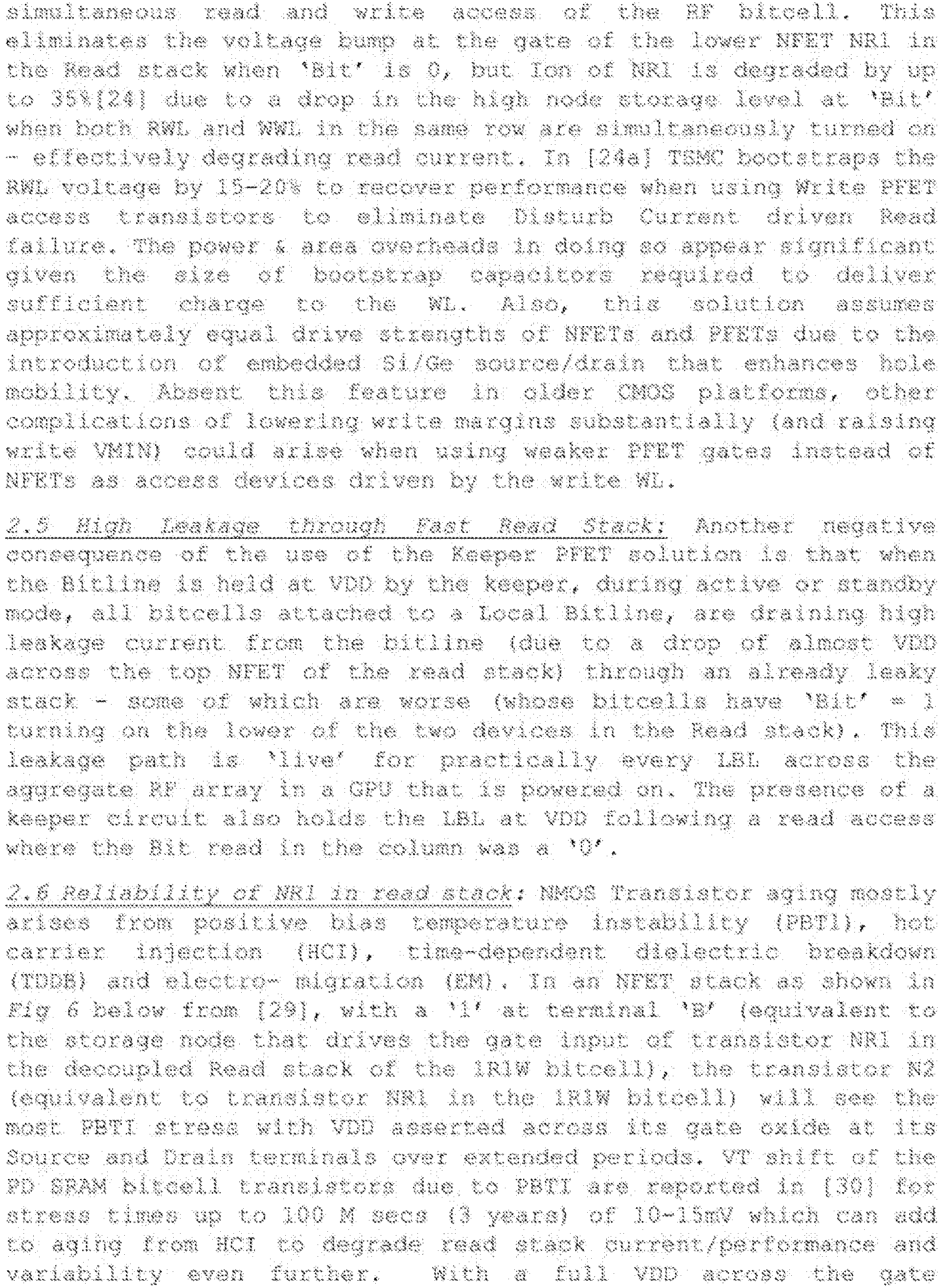

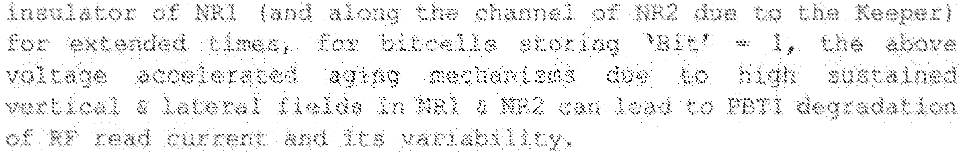

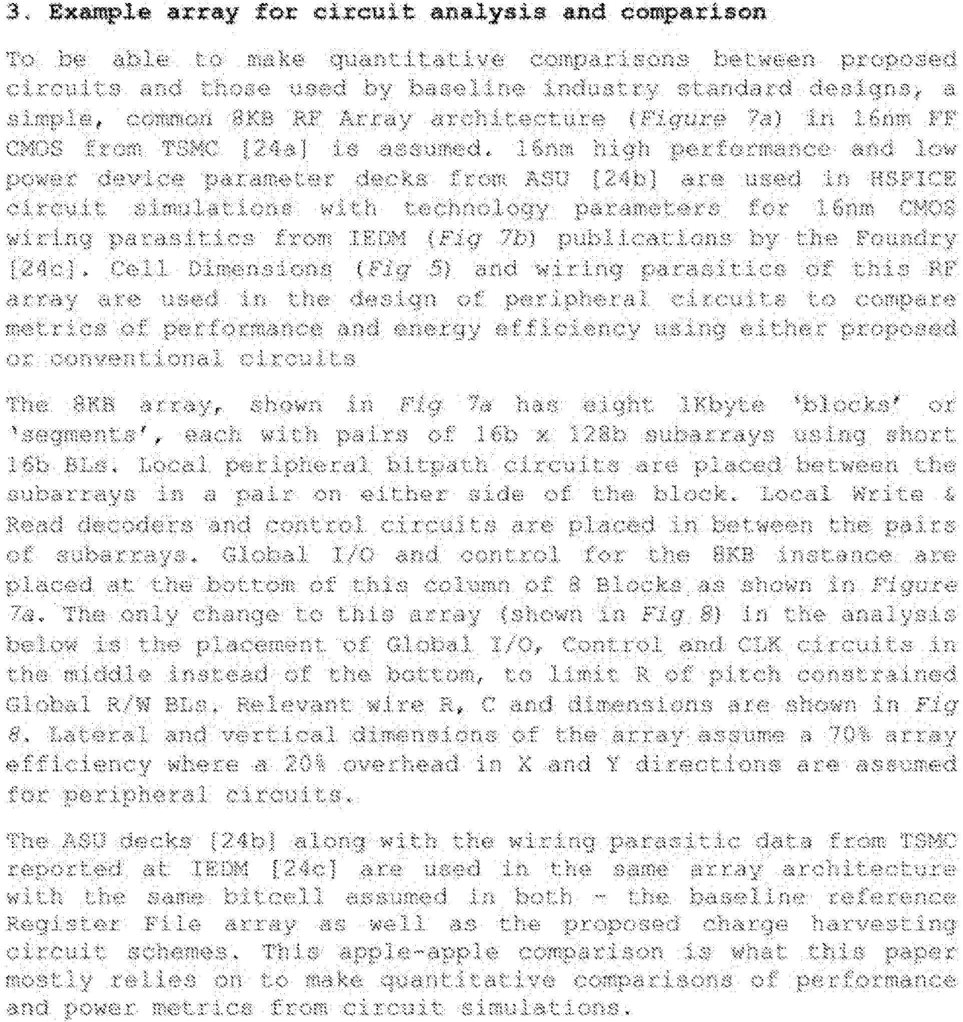

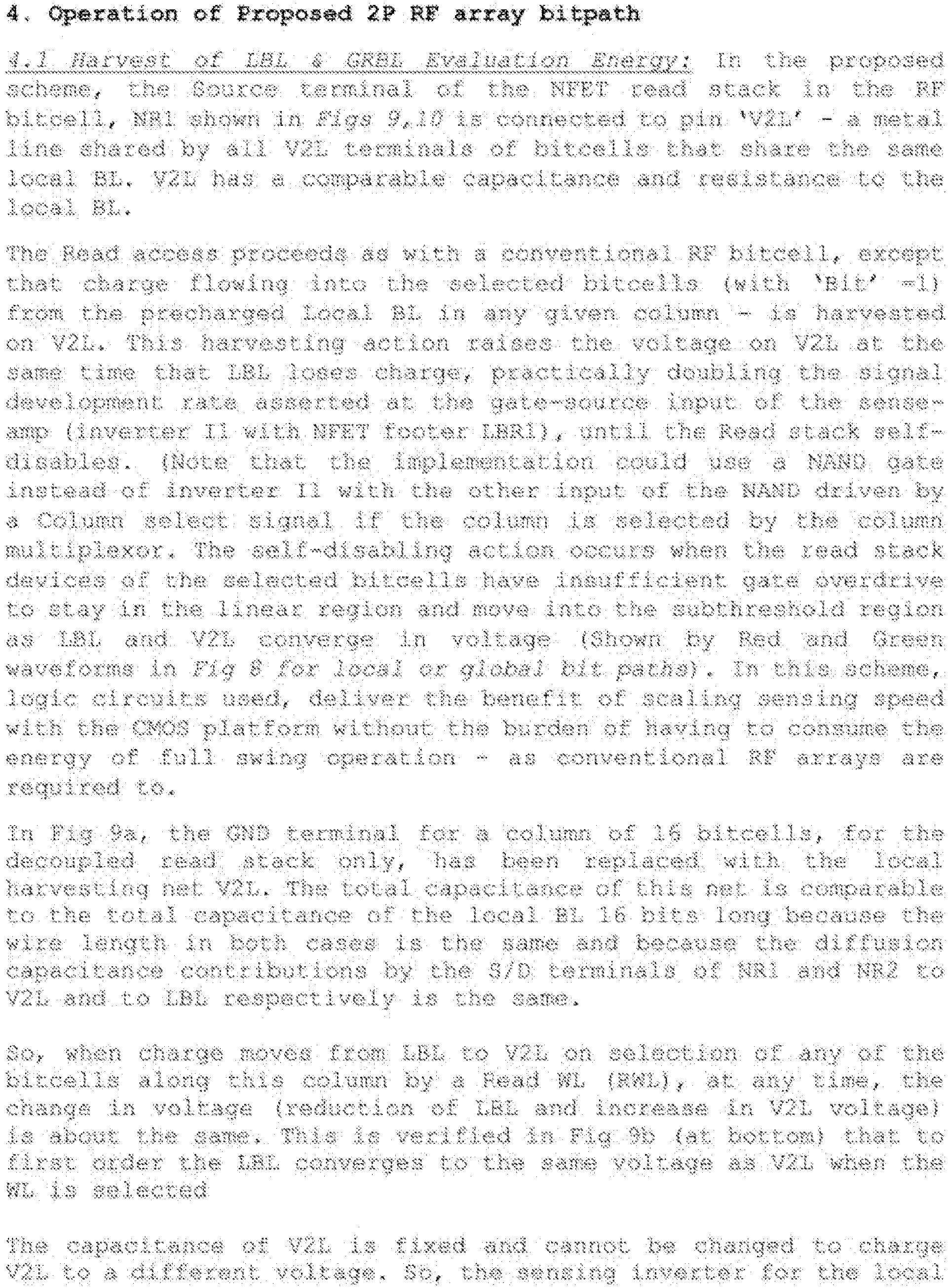

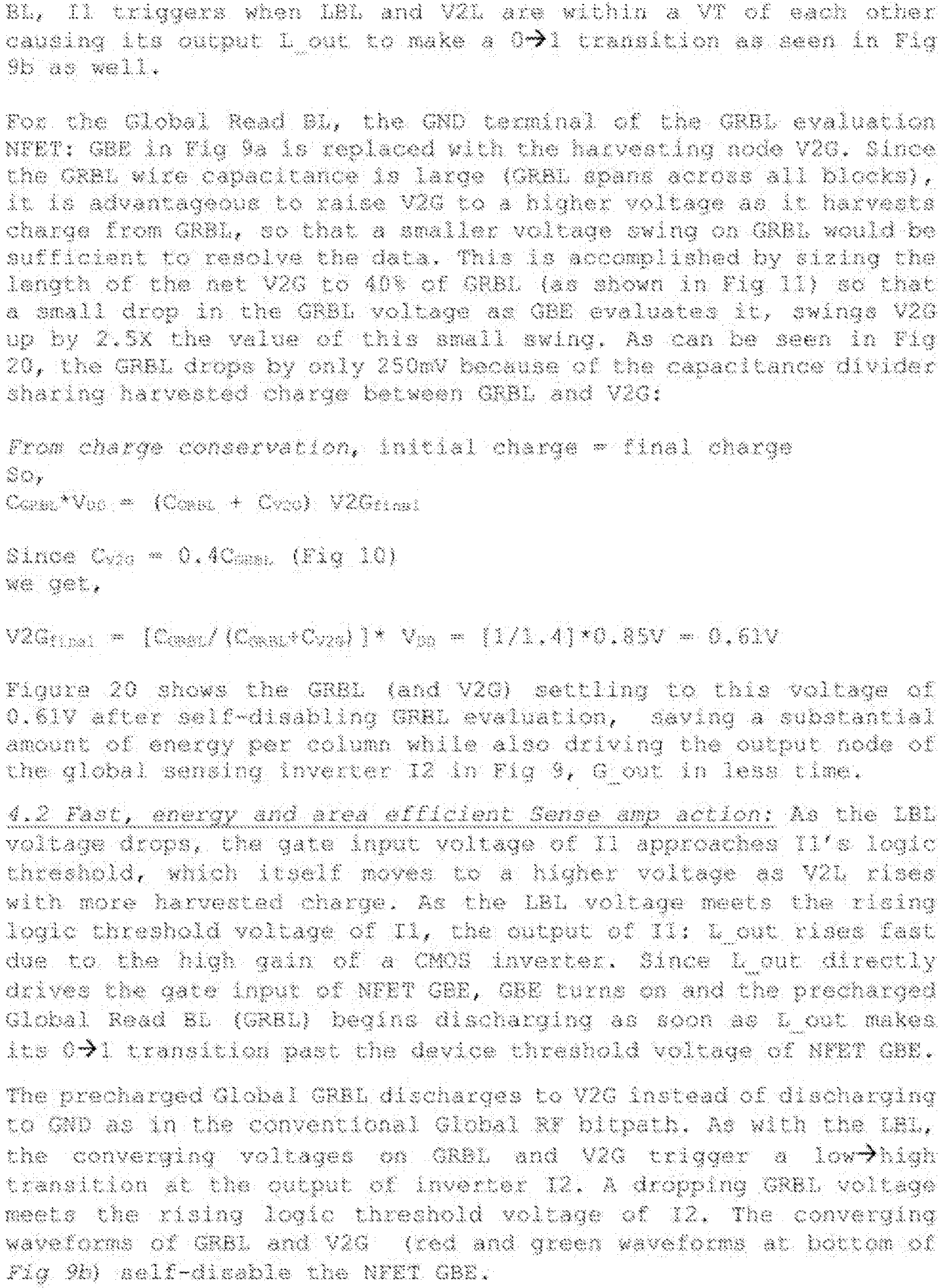

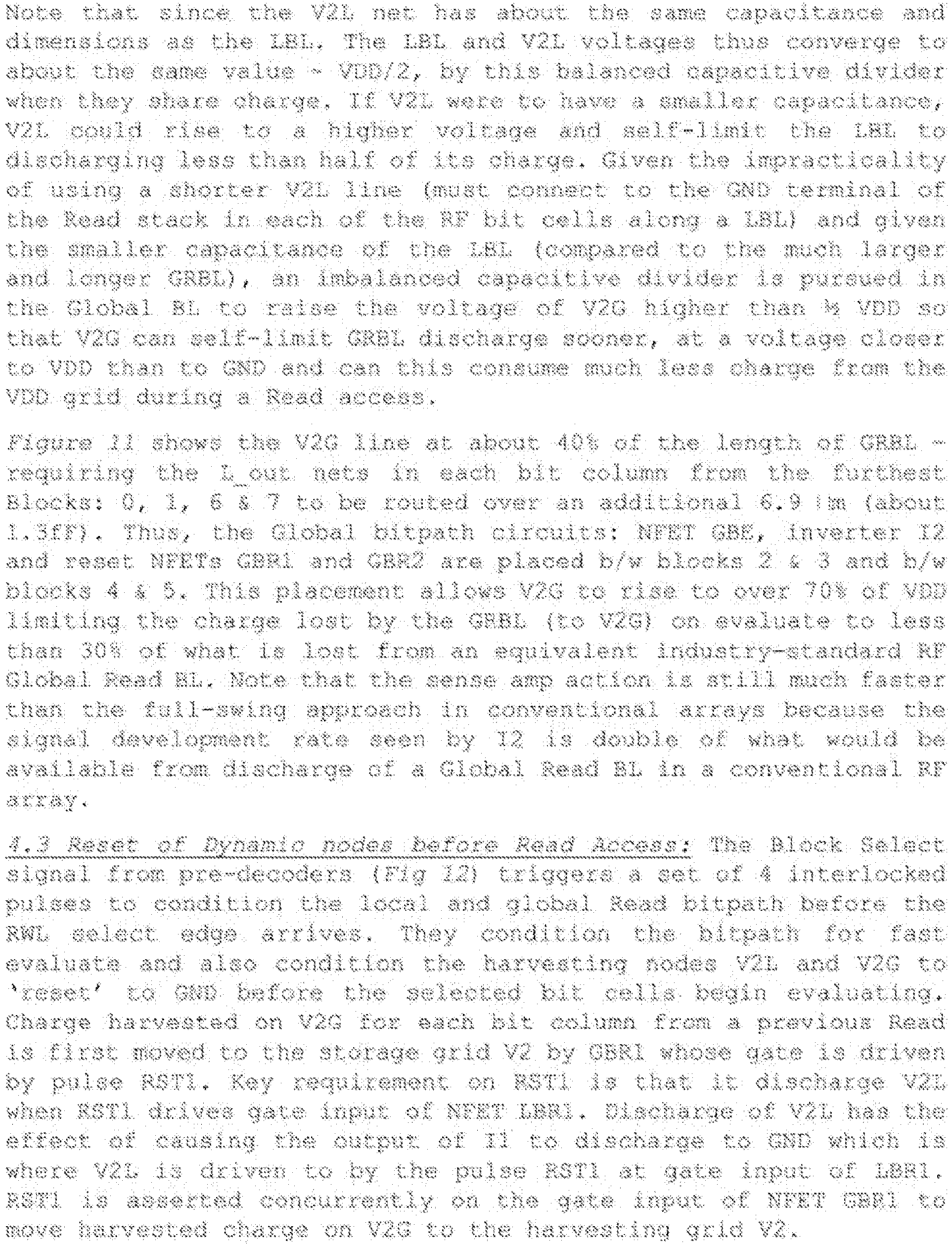

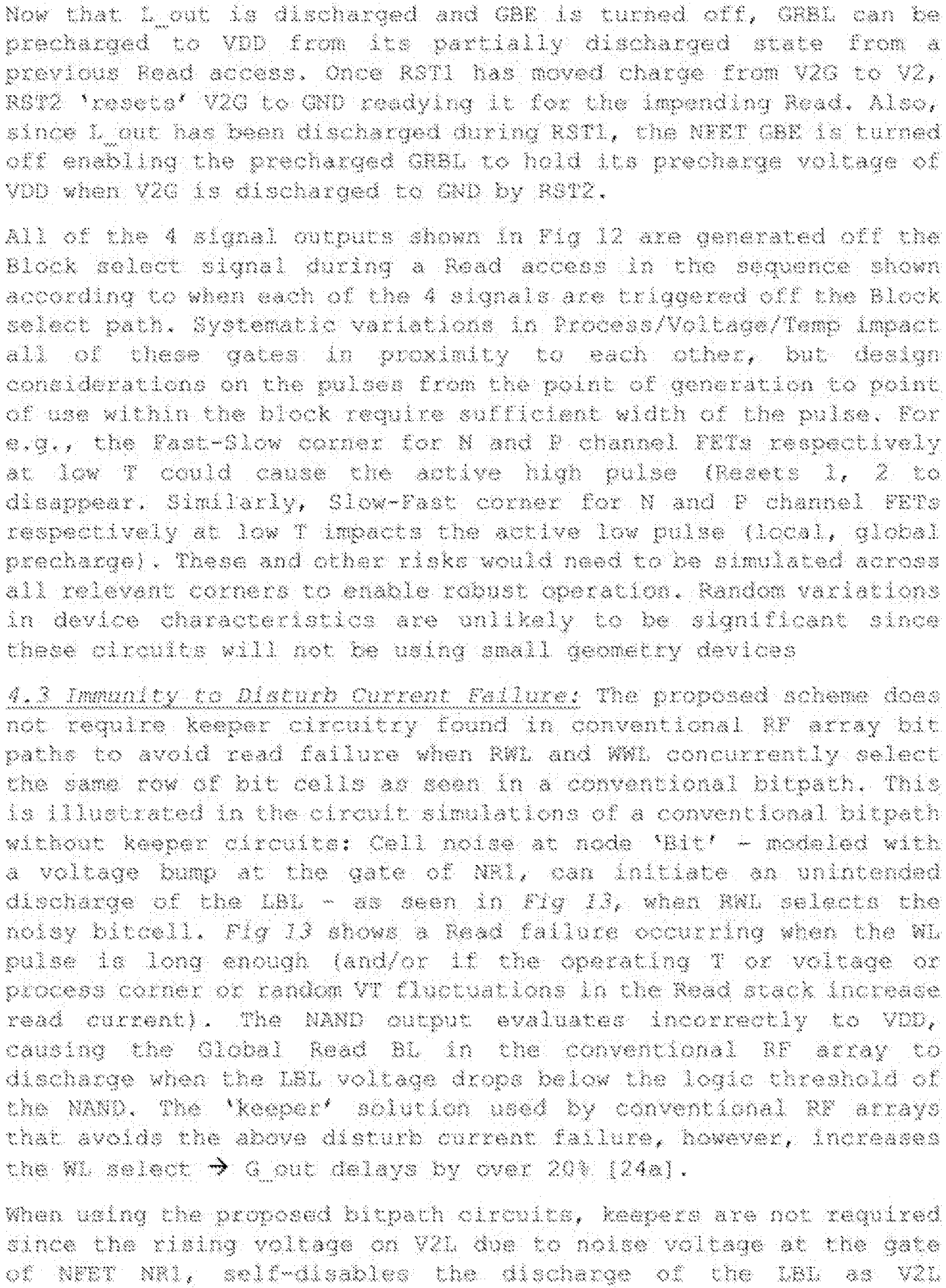

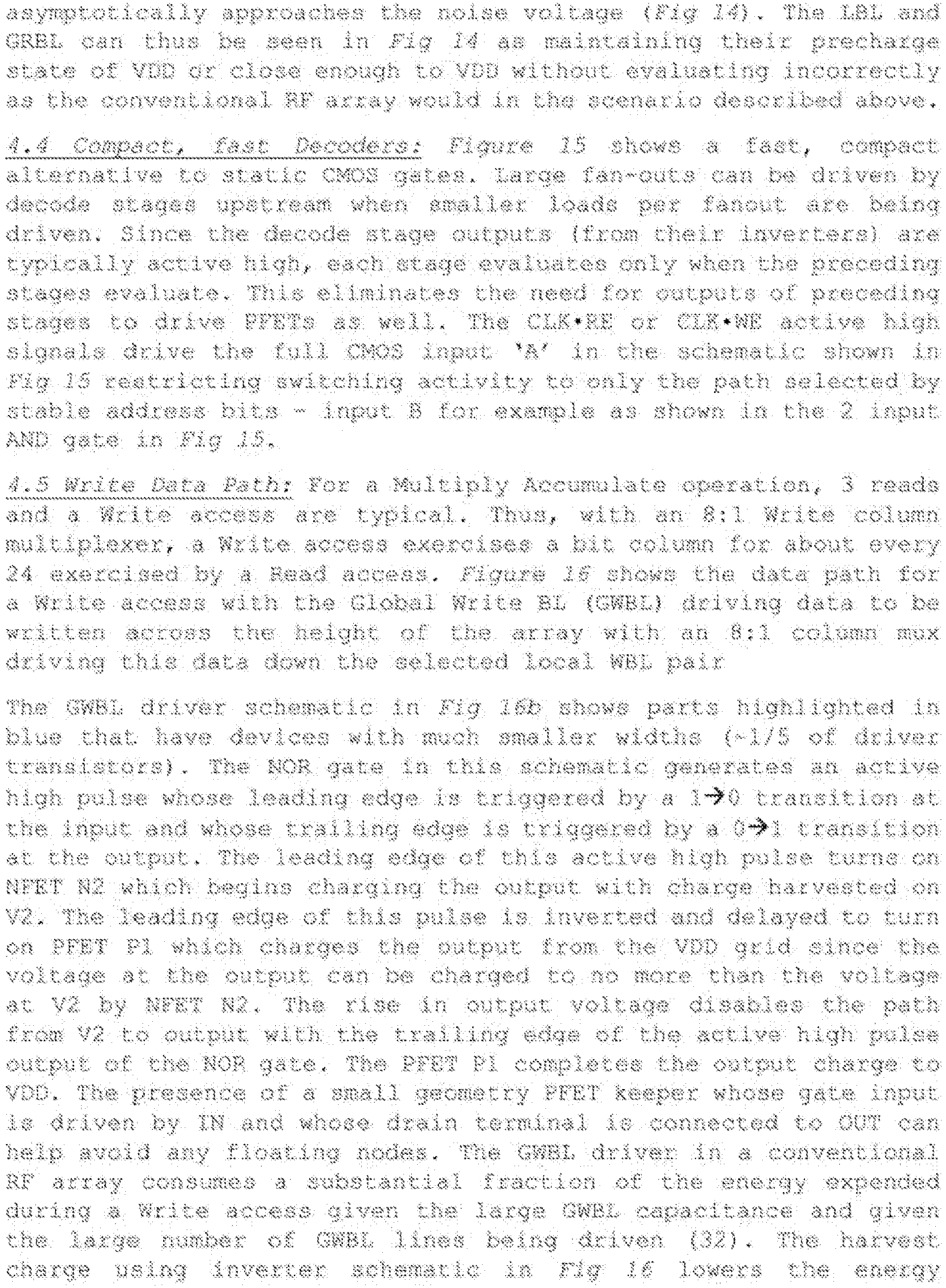

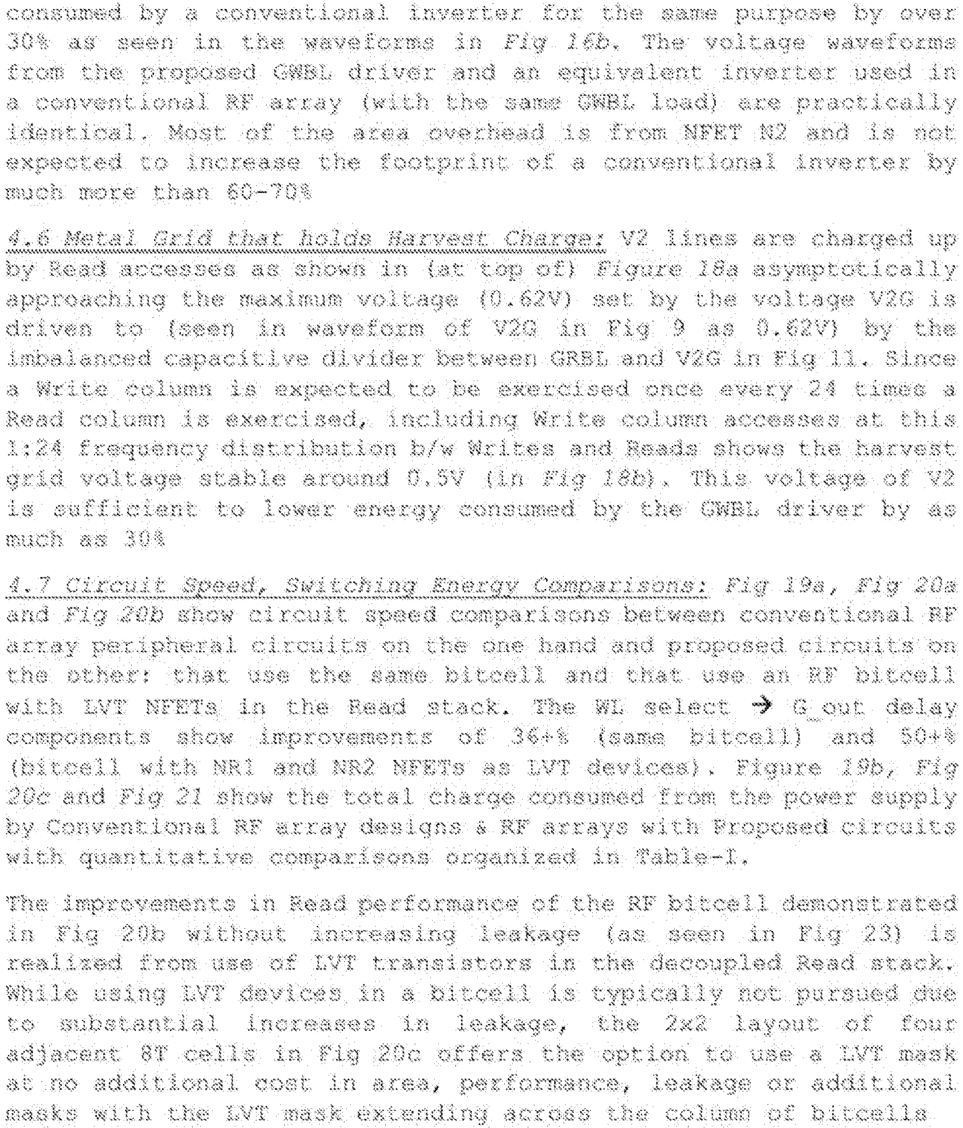

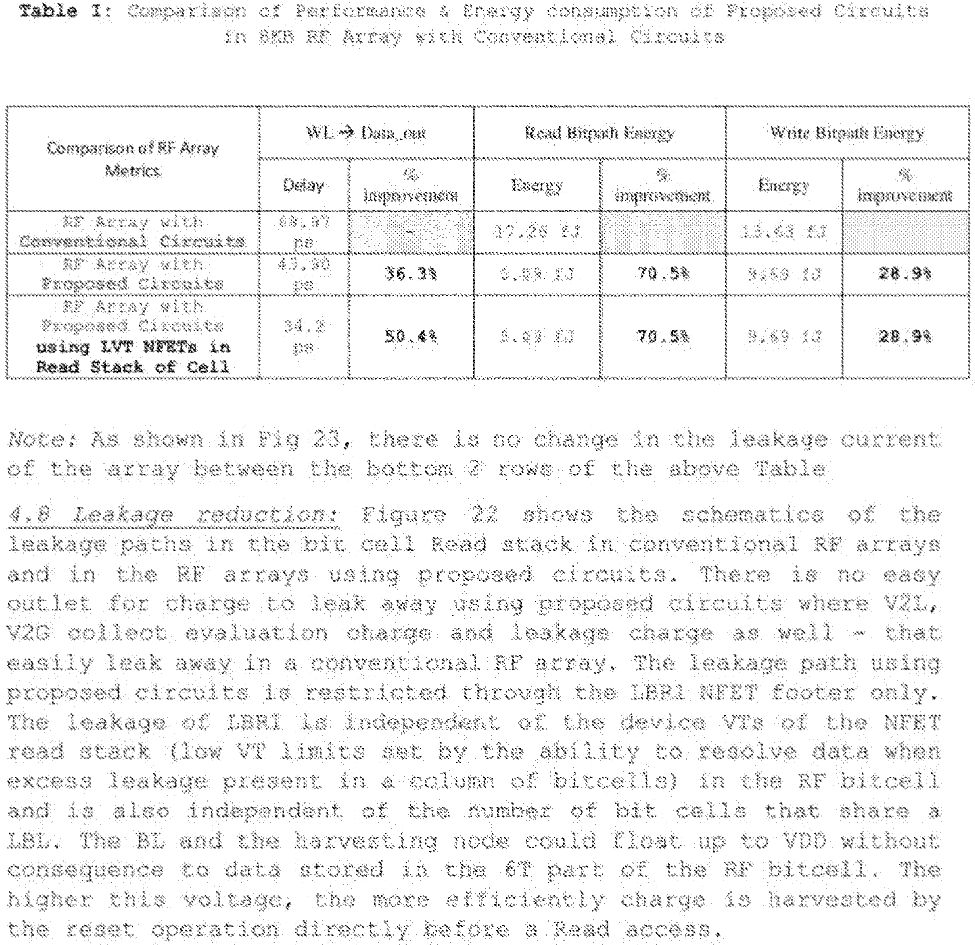

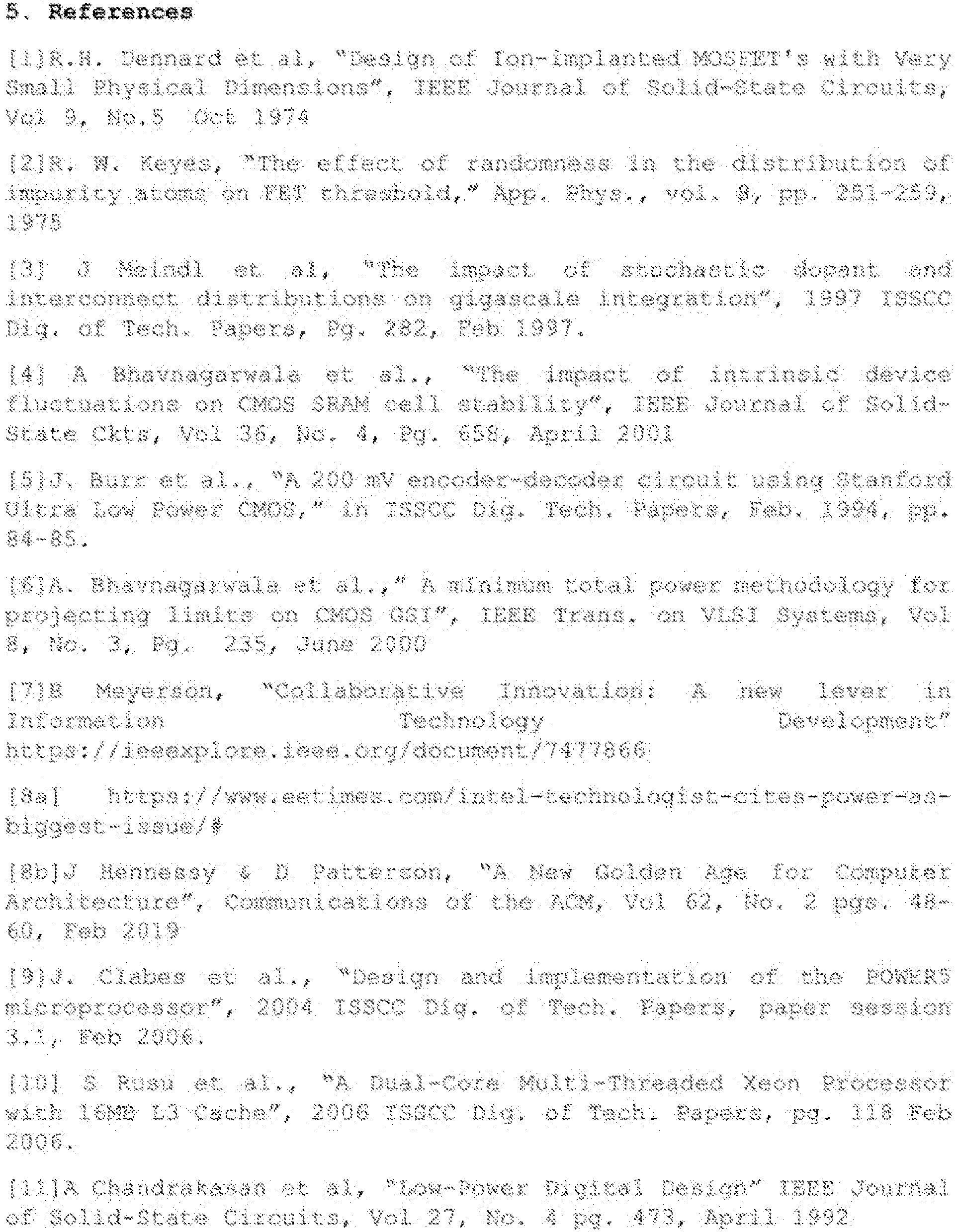

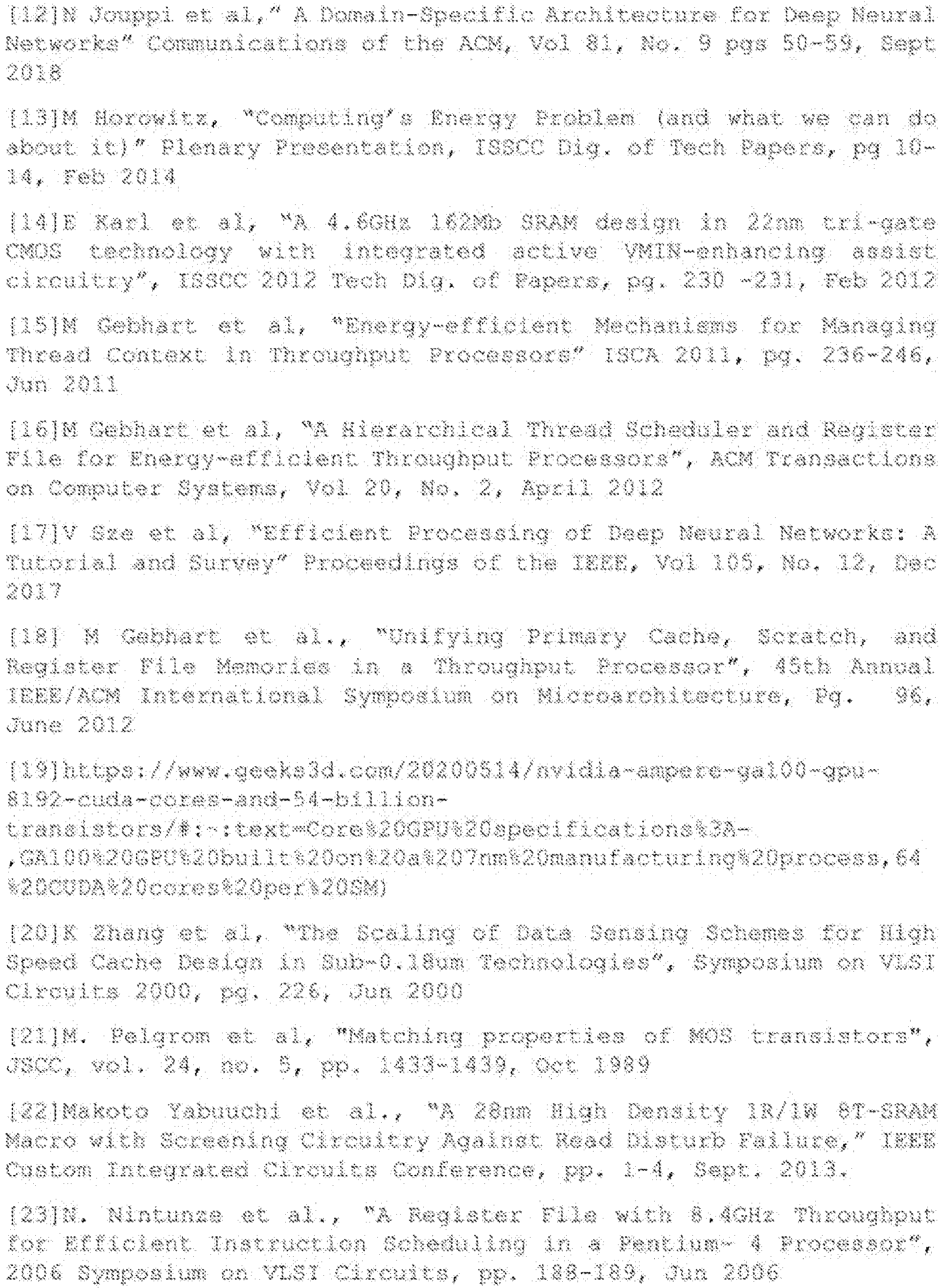

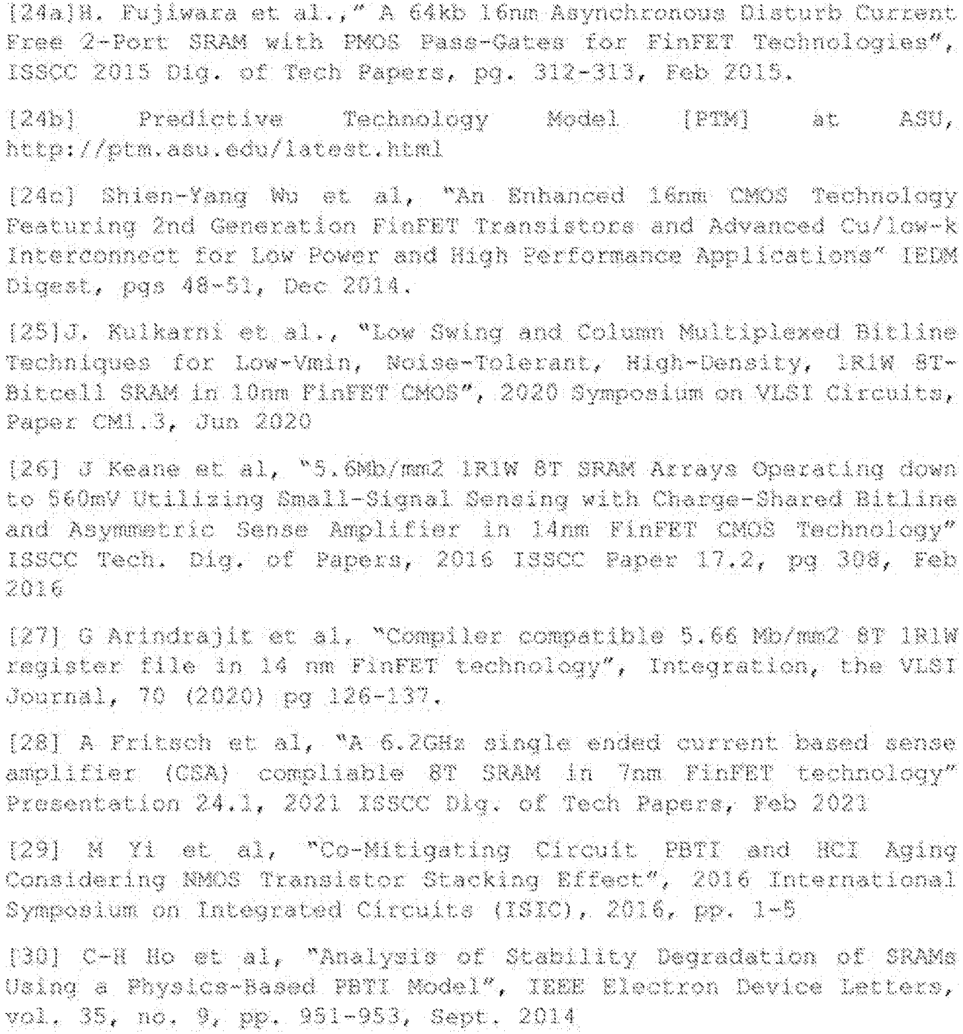

## Claims

1. A Register File memory device comprising:
a plurality of conventional 8 transistor 2 port storage elements each with 1 read port and 1 write port and each with a decoupled read stack of a pair of NFETs with the gate input of one driven by a Read word line and the gate input of the other in the pair driven by a cell storage node.
a harvest terminal that replaces the reference ground potential terminal of the decoupled read stack of FETs in a conventional Register File storage element.
a harvest circuit coupled to the harvest terminal of a plurality of storage elements whose Read ports are coupled along a common bitline with the harvest circuit responsive to a read access by self-disabling the development of signal on the bitline, eliminating the uncertainty of signal voltage development on the bitline due to the statistical variation of read current read stack and at least doubling the rate at which data sensed in the selected storage element is resolved.

2. An apparatus, comprising:
a plurality of transistor storage elements, a transistor storage element from the plurality of transistor storage elements including a read port and a write port, the transistor storage element electrically from the plurality of transistor storage elements coupled to a first n-channel field effect transistor (NFET) and a second NFET, the second NFET including a gate terminal configured to be driven by a bitcell including a read word line, the first NFET including a source terminal and a gate terminal such that the gate terminal of the first NFET is configured to be driven by a cell storage node for the read port from the transistor storage element;
a bitline electrically coupled to the read port of the transistor storage element from the plurality of transistor storage elements and configured to be precharged;
a harvesting node electrically coupled to the source terminal of the first NFET and configured to harvest, at the harvesting node, voltage that was precharged at the bitline in response to a read access action and an activation of the cell storage node;
a harvest inverter including a reference ground potential terminal configured to be replaced with the harvesting node, the harvest inverter including a gate terminal configured to be electrically coupled to the read port of the transistor storage element from the plurality of transistor storage elements; and
a harvesting grid electrically coupled to the harvesting node, the harvesting grid configured to self-disable a signal development on the bitline to eliminate an uncertainty of the signal development on the bitline when an electric potential of harvested data on the harvesting node matches a voltage at the bitline from the signal development.

3. The apparatus of claim 2, wherein the harvesting node configured to discharge a voltage to the reference ground potential before the read access through the first NFET having an active high pulse at the gate terminal of the first NFET enabling discharge of the voltage.

4. The apparatus of claim 3, wherein the gate terminal of the harvest inverter is electrically coupled to the bitline, the harvest inverter including an output terminal configured to be triggered by (1) a decreasing electric potential difference between the bitline that is precharged and the harvesting node during the read access when the cell storage node is active and electrically coupled to the first NFET or the second NFET or (2) a voltage substantially equal to a voltage at a power supply terminal that is electrically coupled to the transistor storage element, the output terminal configured to be triggered by movement of electric charge from the gate terminal of the harvest inverter to the harvesting node.

5. The apparatus of claim 2, wherein:
the apparatus is configured to perform a global sensing scheme such that the gate terminal of the harvest inverter is electrically coupled to a global bitline that is electrically coupled to a drain terminal of the first NFET and a drain terminal of the second NFET, the gate terminal of the first NFET and the gate terminal of the second NFET being driven by the bitline,
the reference ground potential terminal of the harvest inverter configured to be replaced with a global harvest terminal that is electrically coupled to the source terminal of the first NFET, the global harvest terminal configured to harvest charge from the global bitline that is precharged as the first NFET is triggered by a rising output at an output terminal of the harvest inverter.

6. The apparatus of claim 2, wherein the transistor storage element from the plurality of transistor storage elements is configured to be decoupled from the first NFET and the second NFET to enable a higher read performance without compromising read stability margins.

7. The apparatus of claim 2, wherein a discharge of voltage at the bitline is configured to stop in response to a rising voltage at the harvesting node asymptotically approaching a noise voltage at the gate terminal of the first NFET.

8. The apparatus of claim 2, wherein a voltage signal developed at the bitline is determined by a capacitive divide electrically coupled between the bitline and the harvesting node.

9. The apparatus of claim 2, wherein harvested charge stored at the harvesting node is configured to self-disable a flow of read current as the harvested charge at the harvesting node approaches a noise voltage at the bit storage node.

10. The apparatus of claim 2, wherein the signal development on the bitline is configured to self-disable as the electric potential of the harvested data at the harvesting node rises to equalize a dropping voltage of the bitline.

11. The apparatus of claim 2, wherein the harvesting grid is configured to self-disable when the first NFET and the second NFET have insufficient gate overdrive.

12. The apparatus of claim 2, wherein a capacitance of the harvesting node is fixed and cannot be changed to charge the harvesting node to a different voltage.

13. The apparatus of claim 2, wherein a voltage at the harvesting node is configured to increase while the bitline loses charge, to increase a signal development rate for the voltage signal.

14. The apparatus of claim 2, wherein a change in voltage, in response to a charge being transferred from the bitline to the harvesting node when the bitline including the read word line is selected, is the same as when a bitline including a write word line is selected.

15. The apparatus of claim 2, further comprising an inverter electrically coupled to the bitline and the harvesting node, the inverter including an input terminal and an output terminal, the output terminal configured to perform a low-to-high transition in response to a voltage at the bitline and a voltage at the harvesting node being within a voltage threshold.

16. The apparatus of claim 2, wherein increasing a voltage at the harvesting node occurs at a same time as and at a same rate of a voltage at the bitline is lowered.
